# EUROPEAN PATENT SPECIFICATION

(11) **EP 0 344 719 B1**
(45) Date of publication and mention of the grant of the patent: **07.02.1996**
(21) Application number: 89109746.1
(22) Date of filing: 30.05.1989
(51) Int. Cl.: H01L 23/48, H01L 23/50

(54) **Electric circuit device**
Elektrische Schaltungsanordnung
Dispositif à circuit électrique

(30) Priority: 31.05.1988 JP 133396/88; 31.05.1988 JP 133397/88
(43) Date of publication of application: 06.12.1989
(73) Proprietor: CANON KABUSHIKI KAISHA, Tokyo (JP)
(72) Inventor: Yoshizawa, Tetsuo, Yokohama-shi Kanagawa-ken (JP); Terayama, Yoshimi, Odawara-shi Kanagawa-ken (JP); Kondo, Hiroshi, Yokohama-shi Kanagawa-ken (JP); Sakaki, Takashi, Chiyoda-ku Tokyo (JP); Haga, Shunichi, Yokohama-shi Kanagawa-ken (JP); Ichida, Yasuteru, Machida-shi Tokyo (JP); Konishi, Masaki, Ebina-shi Kanagawa-ken (JP)
(74) Representative: Tiedtke, Harro, Dipl.-Ing.

(56) References cited:
- EP-A- 0 284 820
- US-A- 4 667 219
- IBM TECHNICAL DISCLOSURE BULLETIN, vol. 23, no. 7A, December 1980, New York, US, pp. 2716-2717 ; J. HOLSOPPLE et al.: "Increased useable I/O pins on a substrate"

## Description

### 1. Field of the Invention

This invention relates to an electric circuit device which is formed by connecting electrically together electric circuit components via electric connecting members.

### 2. Related Background Art

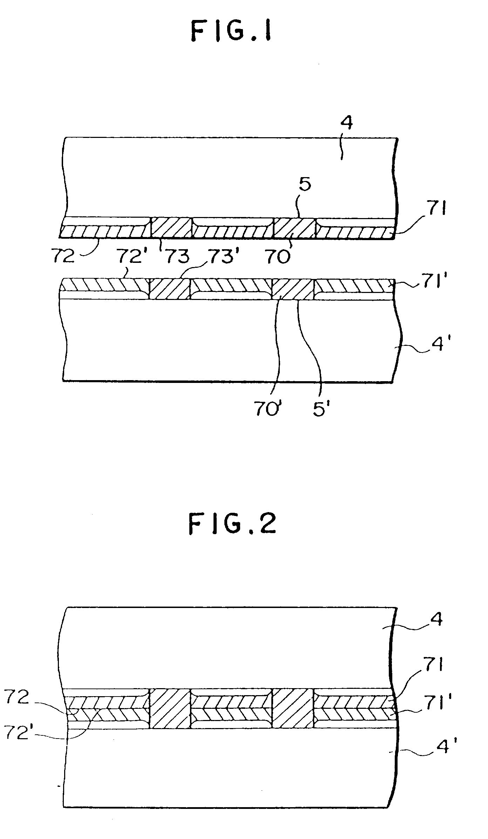

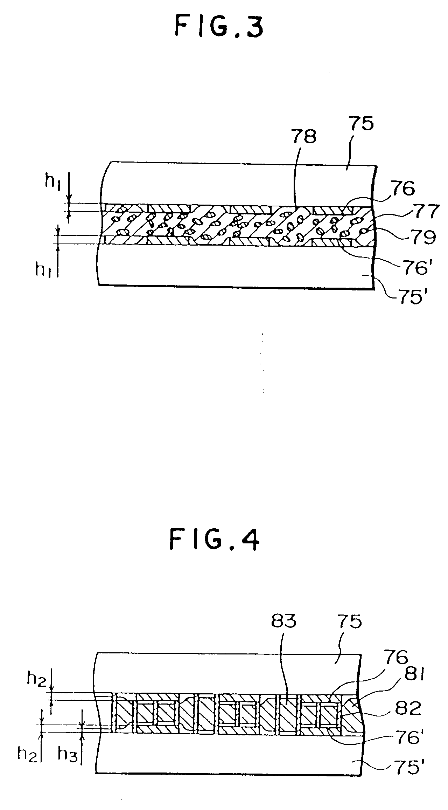

Heretofore, as techniques for electrically connecting together electric circuit components, there have been, for example,
1) wire bonding method
2) TAB (Tape Automated Bonding) method (refer to, for example, Japanese Patent Public Disclosure (Kokai) No. 59-139636 (1984))
3) CCB (Controlled Collapse Bonding) method (refer to, for example, Japanese Patent Publication No. 42-2096 (1967), and Japanese Patent Public Disclosure (Kokai) No. 60-57944 (1985))
4) a method shown in FIGS.1 and 2
5) a method shown in FIG. 3 and
6) a method shown in FIG. 4.

Now, 4) a method shown in FIGS. 1 and 2 is as follows.

That is, an insulating film 71 made of polyimide is formed on portions other than a connecting region 5 of a first semiconductor device 4, a metal material 70 consisting of Au is provided on the connecting region 5, and exposed surfaces 73 and 72 of the metal material 70 and insulating film 71 are then made flat. On the other hand, an insulating film 71' made of polyimide is formed on portions other than a connecting region 5' of a second semiconductor device 4', a metal material 70' consisting of Au is provided on the connecting region 5', and exposed surfaces 73' and 72' of the metal material 70' and insulating film 71' are then made flat.

Subsequently, the first semiconductor device 4 and the second semiconductor device 4' are then located to each other as shown in FIG. 2. After the locating, the connecting region 5 of the first semiconductor device 4 and the connecting region 5' of the second semiconductor device 4' are connected to each other via the metal materials 70 and 70' by performing thermocompression.

Next, 5) a method shown in FIG. 3 is as follows.

That is, an anisotropic conductive film 78 consisting of an insulating film 77 in which conductive particles 79 are dispersed is provided between a first circuit substrate 75 and a second circuit substrate 75'. After locating the first circuit substrate 75 and the second circuit substrate 75' to each other, a connecting region 76 of the first circuit substrate 75 and a connecting region 76' of the second circuit substrate 75' are connected to each other by pressurizing or pressurizing/heating.

6) a method shown in FIG. 4 is as follows.

That is, an elastic connector 83 consisting of an insulating material 81 in which metal wires 82 consisting of Fe or Cu are disposed in a definite direction is provided between the first circuit substrate 75 and the second circuit substrate 75'. After locating the first circuit substrate 75 and the second circuit substrate 75' to each other, the connecting region 76 of the first circuit substrate 75 and the connecting region 76' of the second circuit substrate 75' are connected to each other by pressurizing.

Now, conventional bonding methods as described above have the following problems. That is, there exist restrictions in circuit design relative to bonding, a pitch size between adjacent conductors (a distance between centers of adjacent connecting regions) is large, a thinner device can not be realized, reliability is low due to corrosion or disconnection of conductors, deterioration in characteristics caused by the concentration of thermal stress between a bonding member and an electric circuit component , it is difficult to replace only an electric circuit component when the electric circuit component fails.

In the technique shown in FIGS. 1 and 2, there are the following problems.
a) The exposed surface 72 of the insulating film 71 and the exposed surface 73 of the metal material 70, or the exposed surface 72' of the insulating film 71' and the exposed surface 73' of the metal material 70' must be made flat. Hence, production process for that purpose is increased, and production cost becomes high.
b) If there exists an unevenness between the exposed surface 72 of the insulating film 71 and the exposed surface 73 of the metal material 70, or between the exposed surface 72' of the insulating film 71' and the exposed surface 73' of the metal material 70', the metal material 70 and the metal material 70' become disconnected to each other, and so reliability is decreased.

Furthermore, in the technique shown in FIG. 3, there are the following problems.
a) When connecting the connecting region 76 and the connecting region 76' by pressurizing after locating them to each other, it is difficult to apply a uniform pressure. Hence, there occur variations in connecting state, and as a result, variations in contact resistance value at the connecting regions become large. This fact causes a decrease in reliability of connection. In addition, since phenomena such as heating occur when a large amount of current is passed, this method is unsuitable when it is intended to pass a large amount of current.
b) Even if a uniform pressure can be applied, variations in resistance value become large according to an arrangement of the conductive particles 79 in the anisotropic conductive film 78. Reliability in connection is thereby decreased. Furthermore, this method is unsuitable when it is intended to pass a large amount of current.
c) When a pitch between adjacent connecting regions (a distance between centers of adjacent connecting regions) is reduced, a resistance value between adjacent connecting regions becomes small. Hence, this method is unsuitable for a high-density connection.
d) Since resistance values change due to variations in the amount h1 of protrusion of the connecting regions 76 and 76' of the circuit substrates 75 and 75', it is necessary to exactly control the amount of variations of the h1.
e) When the anisotropic conductive film is used for the connection between a semiconductor device and a circuit substrate, and the connection between a first semiconductor device and a second semiconductor device, there exists the disadvantage that bumps must be provided on connecting regions of the semiconductor devices and so production cost becomes high, other than the above-described disadvantages a) - d).

Furthermore, when 6) the technique shown in FIG. 4 is used for the connection between a semiconductor device and a circuit substrate, or the connection between a first semicondutctor device and a second semiconductor device, there are the following problems as indicated by a) - d).
a) It is necessary to apply a pressure, and so it is necessary to provide a pressurizing jig.
b) Since contact resistance between the metal wires 82 of the elastic connector 83 and the connecting region 76 of the first circuit substrate 75 or the connecting region 76' of the second circuit substrate 75' changes according to a pressurizing force and surface state, reliability in connection is small.
c) Since the metal wires 82 of the elastic connector 83 are rigid, the surfaces of the elastic connector 83, the first circuit substrate 75 and the second circuit substrate 75' have a large possibility of being damaged when a pressurizing force is large. On the contrary, reliability in connection becomes small when a pressurizing force is small.
d) Since the amount h2 of protrusion of the connecting regions 76 and 76' of the circuit substrates 75 and 75', the amount h₃ of protrusion of the metal wires 82 of the elastic connector 83 and variations thereof influence variations in resistance value and damage, a contrivance for decreasing the variations is required.

Document US-A-4 667 219 which refers to the preamble of claim 1 discloses an electric circuit device comprising an electric connecting member including a support member made of an electrically insulating material and plural electrically conductive members, buried in the support member and being isolated from one another. First ends of the electrically conductive members are exposed at one surface of the support member, while their second ends are exposed at the opposite surface of the support member. Furthermore, a first electric circuit component has contact regions to which the first ends of the electrically conductive members are connected and a second electric circuit component has contact regions to which the second ends of the electrically conductive members are connected.

Moreover, document "IBM Technical Disclosure Bulletin, Vol. 23, No. 7A, December 1980, pages 2716 to 2717" discloses a similar electric circuit device by describing that a chip is mounted on an upper substrate member having electrically conductive members. The first ends of the electrically conductive members are connected to the chip and the second ends of the electrically conductive members are connected to a lower substrate member.

Furthermore, document EP-A-0 284 820 which falls within the terms of Art. 54(3) EPC discloses an electric circuit device having an electric connecting member made of plural electrically conductive members of circular cross-section which are buried in a support member, such as a resin. A first electric circuit component with connecting regions is connected to the upper surface of the electric connecting member and a second electric circuit component is connected to the lower surface of the electric connecting member.

However, all of these conventional electric circuit devices have a drawback in that due to the circle-like cross-sectional shape of the electrically conductive members a high-density multipoint connection cannot be obtained.

It is, therefore, an object of the present invention to provide an electric circuit device in which a high-density multipoint connection can be obtained and which has a high reliability and is low in production costs.

According to the present invention this object is achieved by an electric circuit device as defined in claim 1.

The advantages of the invention will become apparent and obvious to those skilled in the pertinent art upon referring to the following description provided in connection with the accompanying drawings.

### BRIEF DESCRIPTION OF THE DRAWINGS

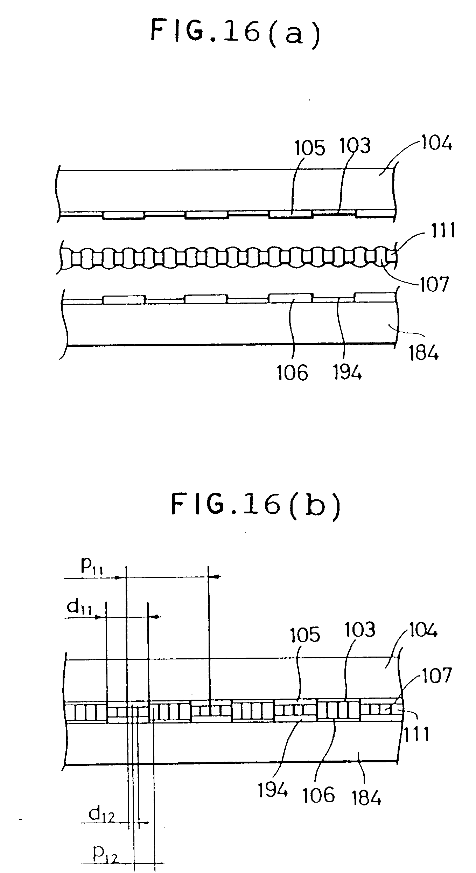

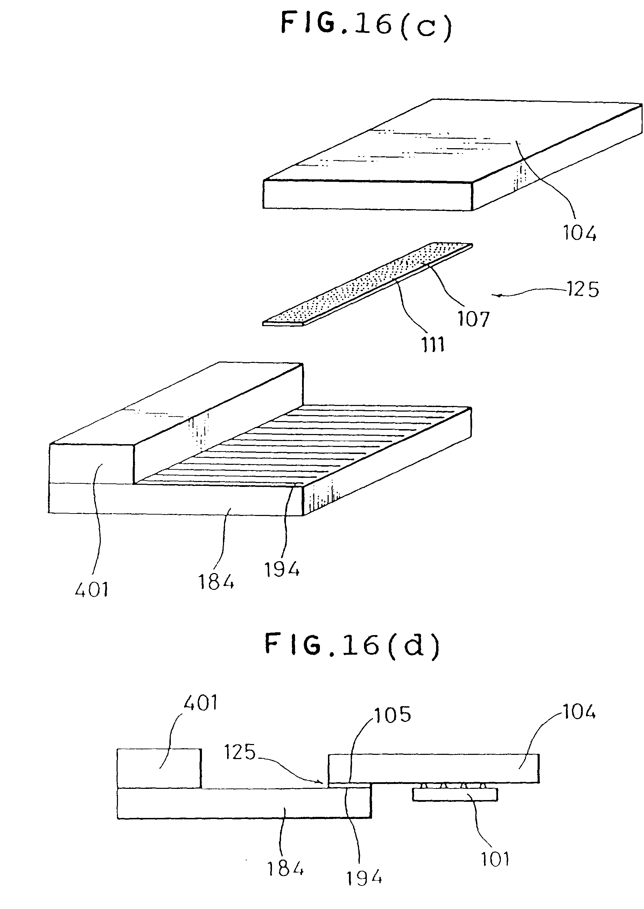

FIGS. 1 through 4 are cross-sectional views showing conventional examples;
FIGS. 5(a) and 5(c), FIGS. 5(b) and 5(d) and FIGS. 5(c)-1 through 5(c)-6 are cross-sectional views showing Examples 1-D1 through Examples 1-E2; FIG. 5(a), FIG. 5(b) and FIGS. 5(c)-1 through FIGS. 5(C)-6 show states before connection, after connection and after sealing, respectively;
FIG. 6 consists of diagrams for explaining an example of the production method of an electric connecting member used in Example 1-D1 through Example 1-E2; FIG. 6(a) is a cross-sectional view, FIG. 6(b) is a plan view, FIG. 6(c) is a cross-sectional view and FIG. 6 (d) is a plan view;
FIG. 7(a) and FIGS. 7(b)-1 through 7(b)-6 show Example 2-D1 through Example 2-E2; FIG. 7(a) is a perspective view,
FIGS. 7(b)-1 through 7(b)-6 are cross-sectional views;
FIGS. 8(a)-1 through 8(a)-6 are cross-sectional views showing Example 3-D1 through Example 3-E2, and FIGS. 8(b)-1 through 8(b)-5 are cross-sectional views showing modified examples of Example 3-D1 through Example 3-E1;
FIGS. 9(a)-1 through 9(a)-6 are cross-sectional views showing Example 4-D1 through Example 4-E2, and FIGS. 9(b)-1 through 9(b)-4 are cross-sectional views showing modified examples of Example 4-D1 through Example 4-D4;

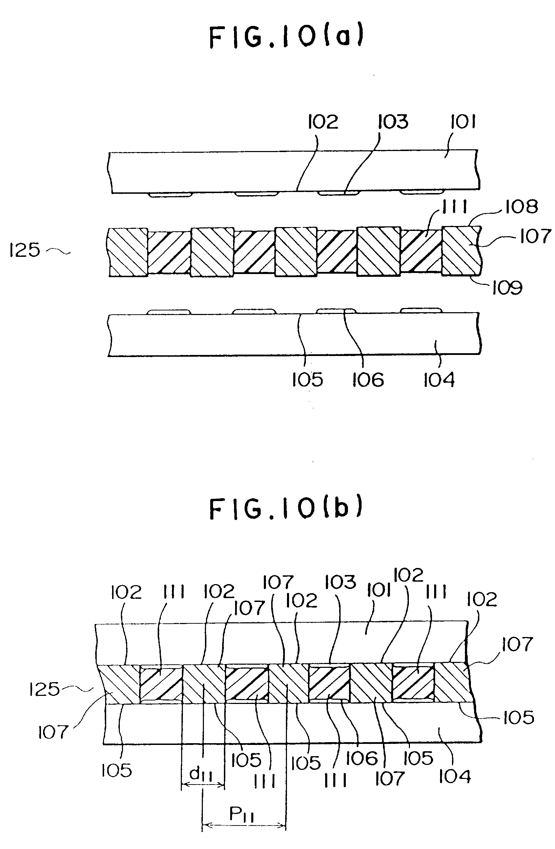

FIG. 10 shows Example 5; FIGS. 10(a) and 10(b) are cross-sectional views showing states before connection and after connection, respectively;

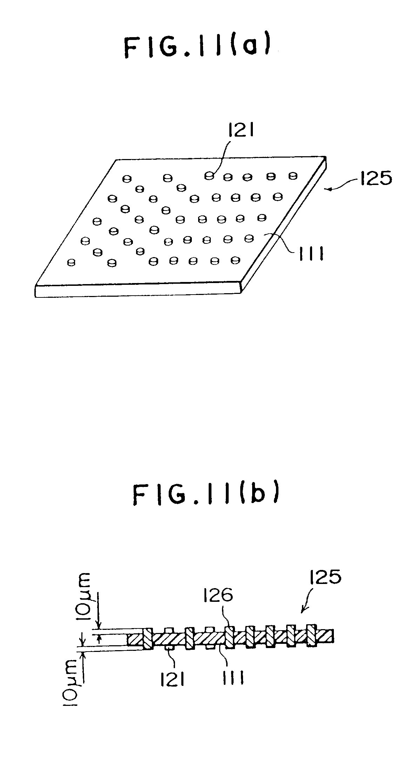

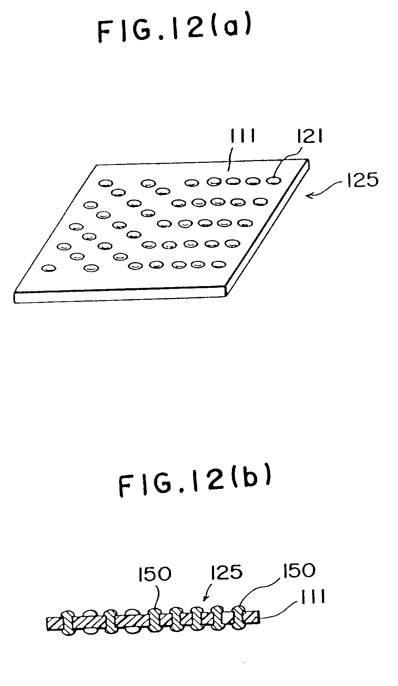

FIGS. 11 and 12 also show Example 5; FIGS. 11(a) and 12(a) are perspective views, and FIGS. 11(b) and 12(b) are cross-sectional views;

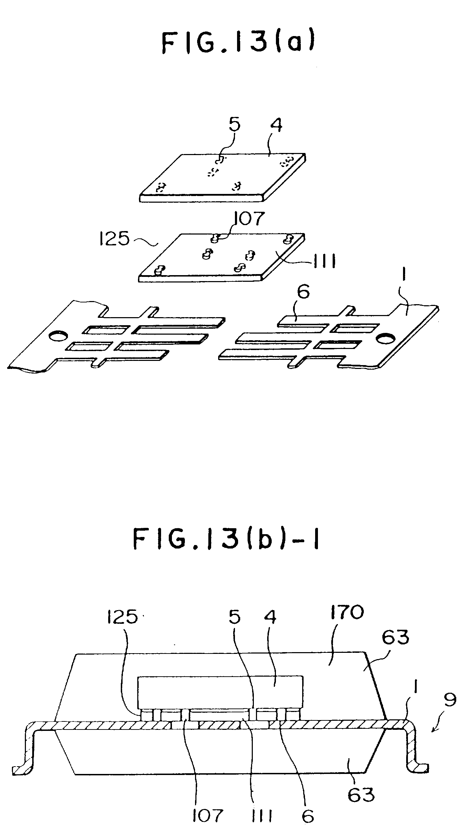

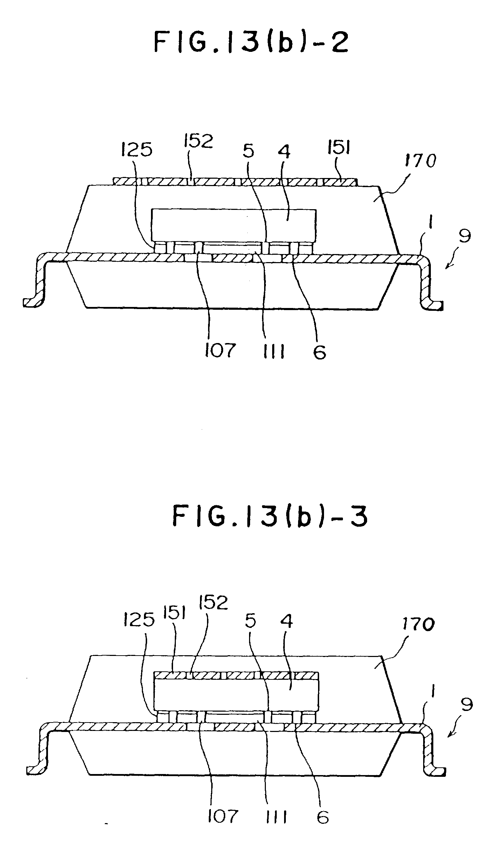

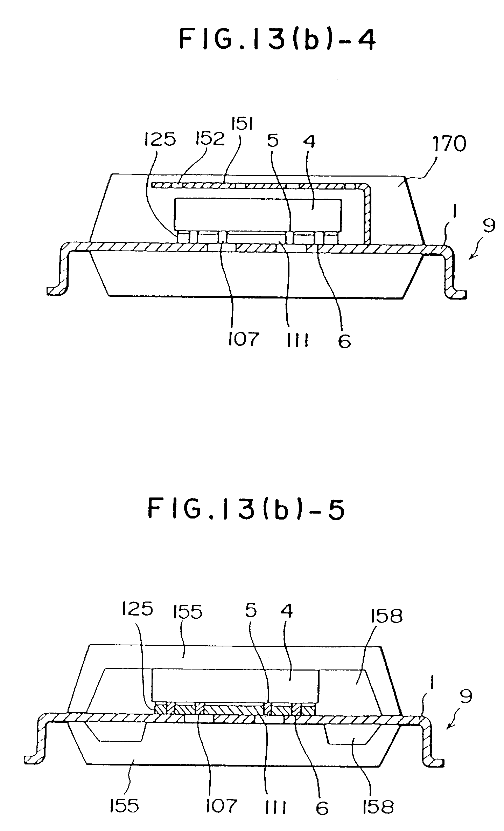

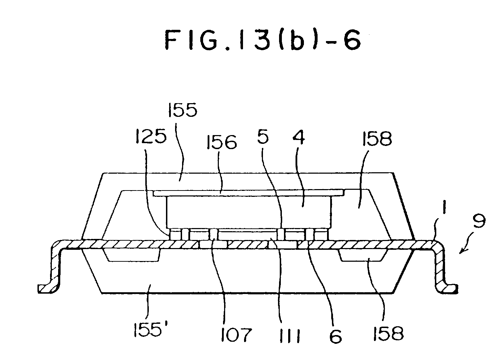

FIG. 13(a) and FIGS. 13(b)-1 through 13(b)-6 show Example 6-D1 through Example 6-E2; FIG. 13(a) is a perspective view showing a state before connection, and FIGS. 13(b)-1 through 13(b)-6 are cross-sectional views showing states after connection;

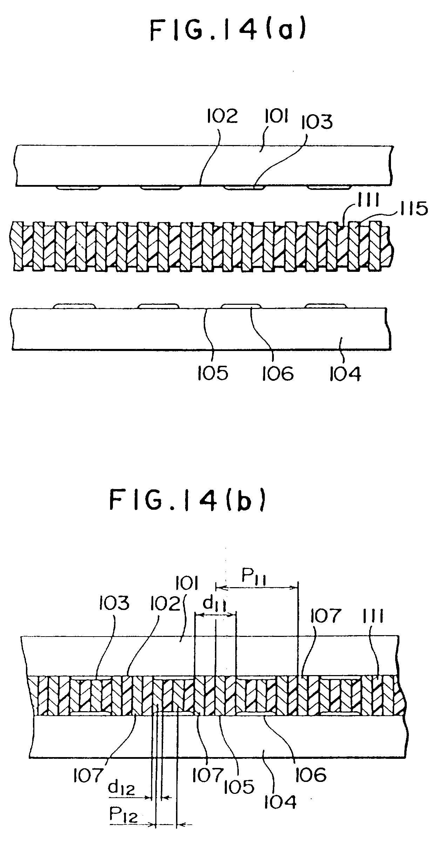

FIG. 14 consists of cross-sectional views showing Example 7; FIGS. 14(a) and 14(b) show states before connection and after connection, respectively;

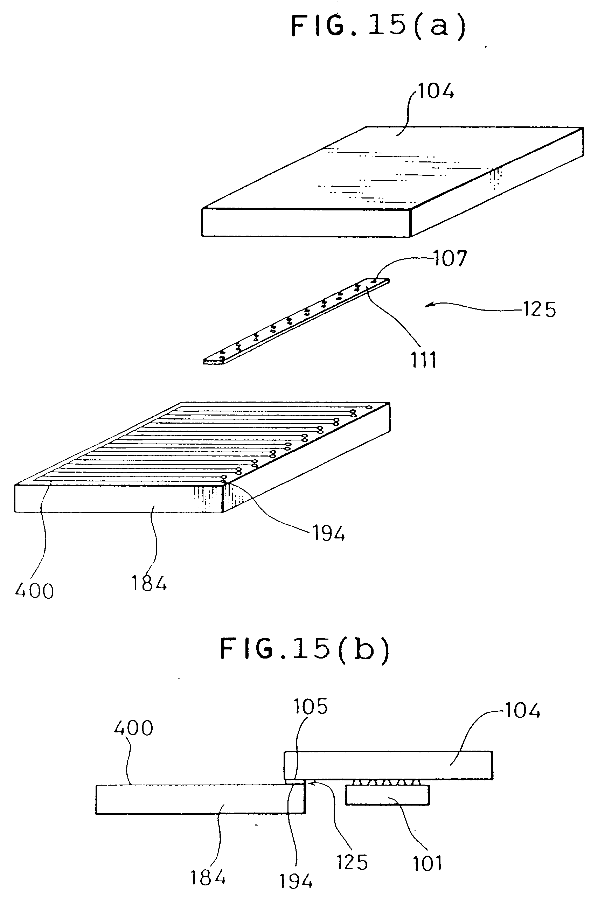

FIG. 15 consists of diagrams showing Example 8; FIG. 15(a) is a cross-sectional view before connection, FIG. 15(b) is a cross-sectional view showing a state after connection and FIGS. 15(c) and 15(d) show a thermal print head; FIG. 15(c) is a perspective view and FIG. 15(d) is a front
view; FIG. 16 shows Example 9; FIG. 16(a) is a cross-sectional view, FIG. 16(b) is a cross-sectional view, FIG. 16(c) is a perspective view and FIG. 16(d) is a front view;

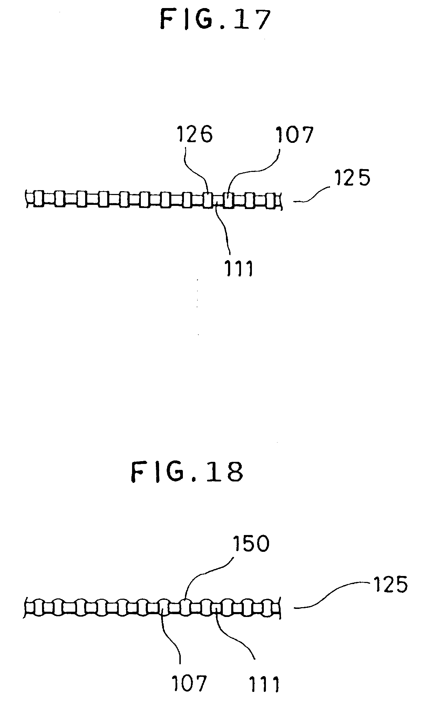

FIGS. 17 and 18 are cross-sectional views of electric connecting members used in Example 10;

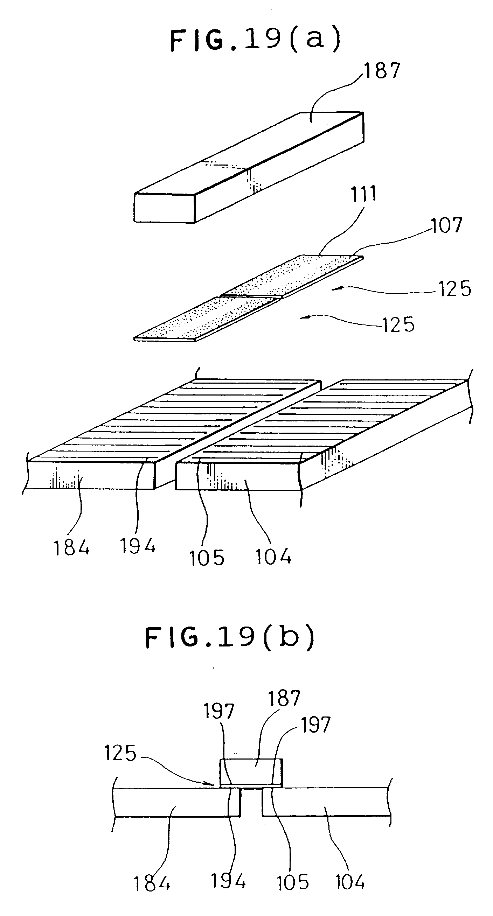

FIG. 19 shows Example 11; FIG. 19(a) is a perspective view and FIG. 19(b) is a front view;

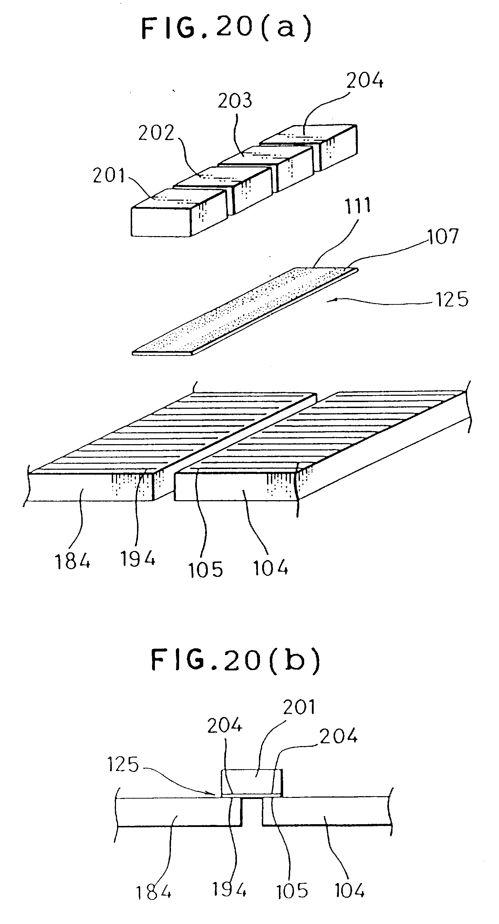

FIG. 20 shows Example 12; FIG. 20(a) is a perspective view and FIG. 20(b) is a front view; and

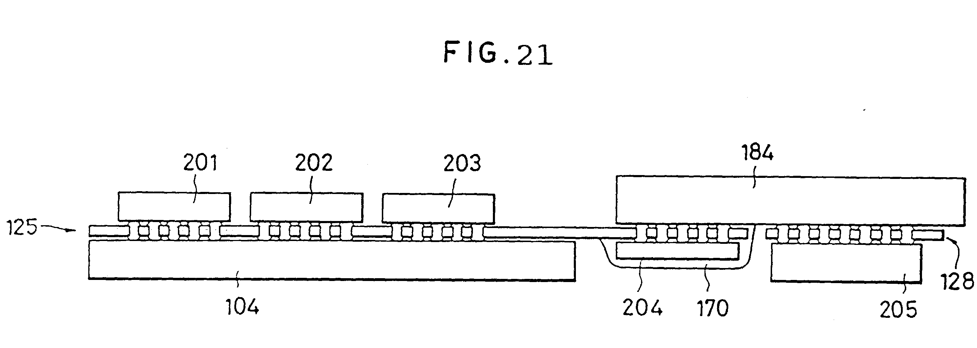

FIG. 21 is a cross-sectional view showing Example 13.

It is to be noted that an explanation about embodiments of the present application other than those described above will be also provided according to the above-described drawings.

### DETAILED DESCRIPTION OF THE PREFERRED EMBODIMENTS

First, main compositional prerequisites of the the present invention will be hereinafter individually explained.

### (Electric circuit components)

As electric circuit components in the present invention , there are, for example, circuit substrates, such as resin circuit substrates, ceramic substrates, metal substrates and, silicon substrates (occasionally, simply termed hereinafter "circuit substrate"), semiconductor devices and, lead frames.

Electric circuit components connected to an electric connecting member may exist only one or in plurality on one surface of a support member.

Components having connecting regions as electric circuit components become objects of the present invention. Although the number of connecting regions is arbitrary, effects of the present invention become more remarkable as the number of connecting regions is larger.

Although the existence positions of connecting regions are also arbitrary, effects of the present invention become more remarkable as they exist in more inner portion of an electric circuit component.

At least two electric circuit components the connecting regions of which exist at end portions of the electric circuit components may be connected on one surface and another surface of an electric connecting member, or may be connected on an identical surface thereof.

It is to be noted that a connecting region is made of an electrically conductive material.

### (Electric connecting members)

An electric connecting member according to the present invention has a configuration that plural electrically conductive members are buried in a support member consisting of an electrically insulating material. The buried conductive members are electrically insulated to one another.

One ends of the electrically conductive members are exposed at one surface of the support member, and other ends are exposed at another surface of the support member.

Furthermore, an electric connecting member may consist of one layer or a multilayer consisting of not less than two layers.

### (Electrically conductive members)

Any material can be used as electrically conductive members provided that it is electrically conductive. Metal materials are commonly used.

As a material for a metal member, gold is preferable, but any metals other than gold or alloys may also be used. Such metals and alloys are, for example, Ag, Be, Ca, Mg, Mo, Ni, W, Fe, Ti, In, Ta, Zn, Cu, Al, Sn, Pb-Sn.

Relative to metal members and alloy members, an identical kind of metal or different kinds of metals may exist within an identical electric connecting member. Furthermore, one of metal members or alloy members of an electric connecting member may consist of an identical metal or alloy, or different metals or alloys. Other than metals or alloys, a material in which one or both of an organic material and an inorganic material are contained in a metal material may also be used, provided that it is conductive. A combination of an inorganic material and an organic material may also be used, provided that it is conductive.

### (Arrangement and shape of an electric connecting member)

In an advantageous embodiment the invention has a feature that ends of electrically conductive members exposed from a support member of an electric connecting member are arranged in a zigzag form.

Plural zigzag rows may also be formed provided that there exists a zigzag form.

The present invention has also a feature that the form of ends of electrically conductive members exposed from a support member of an electric connecting member is wave-like or s-like. Also in this case, a portion within a support member may have any form. The form of connecting regions of an electric circuit component may be wave-like, s-like, or other shapes.

The size of an electrically conductive member is not specifically limited. Considering the pitch of connecting regions of an electric circuit component, the diameter is preferably, for example, not smaller than 20 µmφ, but it may also be not larger than 20 µmφ.

Exposed portions of electrically conductive members may be on a surface identical to that of a support member, or may protrude from the surface of the support member. The protrusion may be on one surface or on both surfaces. When protruded, protruded portions may have the form of a bump.

A spacing between electrically conductive members may be identical to a spacing between connecting regions of an electric circuit component, or may be narrower than that spacing. In the case of a narrower spacing, it becomes possible to connect an electric circuit component to an electric connecting member without locating the electric circuit component relative to the electric connecting member.

Electrically conductive members are not required to be perpendicularly disposed within a support member, but they may be obliquely disposed from one surface toward another surface of the support member.

### (Support member)

A support member is made of an electrically insulating material.

Any material may be used provided that it is an electrically insulating material. As electrically insulating materials, there are organic materials and inorganic materials. Metals or alloy materials subjected to a processing so that electrically conducting members are electrically insulated one other may also be used. Furthermore, one kind or plural kinds of inorganic materials, metal materials and alloy materials which have a desired shape, such as a powder, fibers, plate-like bodies, rod-like bodies and spherical bodies, may also be dispersed and contained within an organic material. Furthermore, one kind or plural kinds of organic materials, metal materials and alloy materials which have a desired shape, such as a powder, fibers, plate-like bodies, rod-like bodies and spherical bodies, may also be dispersed and contained within an inorganic material. Otherwise, one kind or plural kinds of inorganic materials and organic materials which have a desired shape, such as a powder, fibers, plate-like bodies, rod-like bodies and spherical bodies may also be dispersed and contained within a metal material. When a support member consists of a metal material, an electrically insulating material, such as a resin, may, for example, be disposed between electrically conductive members and a support member.

As an organic material, an insulating resin may, for example, be used. As a resin, either of a thermosetting resin, a UV-curable resin and a thermoplastic resin may be used. It is possible to use polyimide resins, polyphenylene sulfide resins, polyether sulfone resins, polyether imide resins, polysulfone resins, fluororesins, polycarbonate resins, polydiphenyl ether resins, polybenzyl imidazole resins, polyamideimide resins, polypropylene resins, polyvinyl chloride resins, polystyrene resins, metyl metacrylate resins, polyphenylene oxide resins, phenol resins, melanin resins, epoxy resins, urea resins, metacrylate resins, vilylidene chloride resins, alkyd resins, silicone resins, and other resins.

It is preferable to use a resin which has an excellent heat-conductive property among these resins, because, even when a semiconductor device has heat, the heat can be radiated through the resin. Furthermore, if a resin which has a coefficient of thermal expansion identical or similar to that of the circuit substrate is selected, and at least one hole or plural air bubbles are provided within the organic material, it is possible to further prevent a decrease in reliability of a device according to thermal expansion/thermal contraction.

As concrete metal materials or alloy materials, there are, for example, metals or alloys, such as Ag, Cu, Au, Al, Be, Ca, Mg, Mo, Fe, Ni, Si, Co, Mn, W, Cr, Nb, Zr, Ti, Ta, Zn, Sn, or Pb-Sn.

As inorganic materials, there are, for example, ceramics, such as SiO₂, B₂O₃, Al₂O₃, Na₂O, K₂O, CaO, ZnO, BaO, PbO, Sb₂O₃, As₂O₃, La₂O₃, ZrO₂, BaO, P₂O₅, TiO₂, MgO, SiC, BeO, BP, BN, AlN, B₄C, TaC, TiB₂, CrB₂, TiN, Si₃N₄, or Ta₂O₅, and other inorganic materials, such as diamond, glasses, carbon, or boron.

### (Connection)

For a connection between an end of an electric connecting member and an electric circuit component, the following three configurations may be considered.
1) A configuration in which all electric circuit components are connected by metallizing and/or alloying connecting regions thereof and one ends of plural electrically conductive members which are exposed on one surface of a support member.
2) A configuration in which at least one electric circuit component is connected by metallizing and/or alloying connecting regions thereof and one ends of plural electrically conductive members which are exposed at one surface of a support member, and other electric circuit components are connected by a method other than metallization and/or alloying.
3) A configuration in which all electric circuit components are connected by a method other than metallization and/or alloying at connecting regions thereof and one ends of plural electrically conductive members which are exposed on one surface of a support member.

### (Connection by metallization and/or alloying)

Now, a connection by metallization and/or alloying will be described.

When electrically conductive members and connecting regions to be connected to one another are made of an identical pure metal, layers formed by metallization have a crystal structure identical to that of the electrically conductive members or the connecting regions. Relative to a method of metallization, after contacting, for example, ends of electrically conductive members with connecting regions corresponding to the ends, they may be heated at an appropriate temperature. In this case, diffusion of atoms occur near the contacting portions by heating, and the diffused portions become in a metallic state to form metallic layers.

When electrically conductive members and connecting regions to be connected to one another are made of different pure metals, connecting layers which are formed are made of an alloy of the two metals. Relative to a method of alloying, after contacting, for example, ends of electrically conductive members with connecting regions corresponding to the ends, they may be heated at an appropriate temperature. In this case, diffusion of atoms occur near the contacting portions by heating, and layers consisting of a solid solution or an intermetallic compound are formed near the contacting portions.

When Au is used as a metal material for an electric connecting member, and Al is used for connecting regions of an electric circuit component, a heating temperature of 200 - 350°C is preferred.

When one of electrically coductive members and connecting regions to be connected to one another is made of a pure metal and the other is made of an alloy, or when the both are made of an identical kind of alloy or different kinds of alloys, the connected interface consists of an alloy layer.

Relative to plural electrically conductive members within one electric connecting member, there are cases such that each electrically conductive member consists of an identical metal or alloy, each consists a different metal or alloy and other cases. Furthermore, relative to one electrically conductive member, there are cases such that it consists of a identical metal or alloy, it consists of different metals or alloys and other cases. In any case, however, the above-described metallization or alloy formation is performed. The situation is the same for connecting regions.

Electrically conductive members or connecting regions may be made of a metal or an alloy at connecting portions of the two. Other portions may be, for example, under the state in which an inorganic material, such as glass, is compounded with a metal or under the state in which an organic material, such as a resin, is compounded with a metal.

A plated layer consisting of a metal which can easily form an alloy or an alloy may also be provided on the surface of portions to be connected to each other.

As a heating method, internal heating methods, such as an ultrasonic heating method, a high-frequency induction heating method, a high-frequency dielectric heating method, a micro-wave heating method, or other external heating methods may also be used other than a thermocompression method, or the above-described methods may be used together. In either heating method, connection is performed by directly or indirectly heating connecting portions.

### (Connection by methods other than metallization and/or alloy formation)

In order to perform connection by a method other than the above-described metallization or alloy formation, connection may, for example, be performed by pressing an electric circuit component and electric conductive members of an electric connecting member.

As other connection methods, there are a connection method using a connecting adhesive.

That is, there is a method in which connection is performed by sticking together an electric circuit component and electrically conductive members at at least some part except the connecting portions thereof.

### (Removable connection)

Among the above-described several connection methods, a method which can perform a removable connection (for example, a connection by pressing) may be selected for electric circuit components which need to be replaced.

When performing connection by metallization and/or alloy formation as well, it may be arranged so that the melting point of the metal layer or alloy layer for electric circuit components to be removed is lower that the melting point of the metal layer or alloy layer for electric circuit components not to be removed. That is, in such a configuration, by heating at a temperature which is higher than the melting point of the metal layer or alloy layer for electric circuit components to be removed and lower than the melting point of the metal layer or alloy layer for electric circuit components not to be removed, only electric circuit components to be removed can be removed without giving bad influences, such as a damage, over connecting regions of electric circuit components not to be removed. In the present invention, the removable connection also includes such a connection.

### (Applications)

As electric circuit components in the present invention, there are, for example, recording heads, such as thermal print heads, ink jet heads, functional heads, such as liquid crystal panels, devices for driving electric circuit devices (for example, driver devices in which driver semiconductor devices exist in proximity), devices for driving long devices having many functional elements, and devices for amplifying long devices having many sensors.

### (Sealing methods)

As a method for sealing by a sealant, electric circuit members (members comprising an electric connecting member and electric circuit components connected thereto) may be housed within a cavity of a mold, and a sealant may be injected into the cavity by injection molding. Electric circuit members may be sealed by such injection molding, or by extrusion, core molding, cavity molding or any other methods.

Furthermore, the above-described sealant and a plate (the plate consists of a material different from the sealant) may also be used together. As such sealing states, there are a case in which a plate is connected to at least a part of the surface of a sealant, a case in which electric circuit components and at least a part of the plate connected to at least a part of at least one of other electric circuit components connected to an electric connecting member at a surface opposite to the electric connecting member is buried by a sealant, and a case in which electric circuit components and at least a part of a plate disposed at near sides of either one or plural electric circuit components connected to an electric connecting member are buried by the sealant.

### (Plate)

The material of the plate is arbitrary provided that it is different from the material of the sealant.

The thickness of the plate is, for example, preferably 0.05 - 0.5 mm in the case of a stainless plate.

When connecting the plate, the method of connection is not specifically limited. The plate may, for example, be sticked using an adhesive or other methods may also be used.

### (Materials for cap sealing)

A material for a cap may be an organic material, an inorganic material, a metal material or a composite material of these materials.

As a sealing state, one electric circuit component or plural electric circuit components may be sealed by an identical cap. Sealing may be performed so that a cap presses an electric circuit component or a cap holds an electric circuit component.

Furthermore, sealing may be performed providing a member between an electric circuit component and a cap. In this case, more remarkable effect can be obtained if plural electric circuit components are sealed by an identical cap.

Connection between a cap and an electric circuit component may be performed by any methods.

### EXAMPLE 1-D1

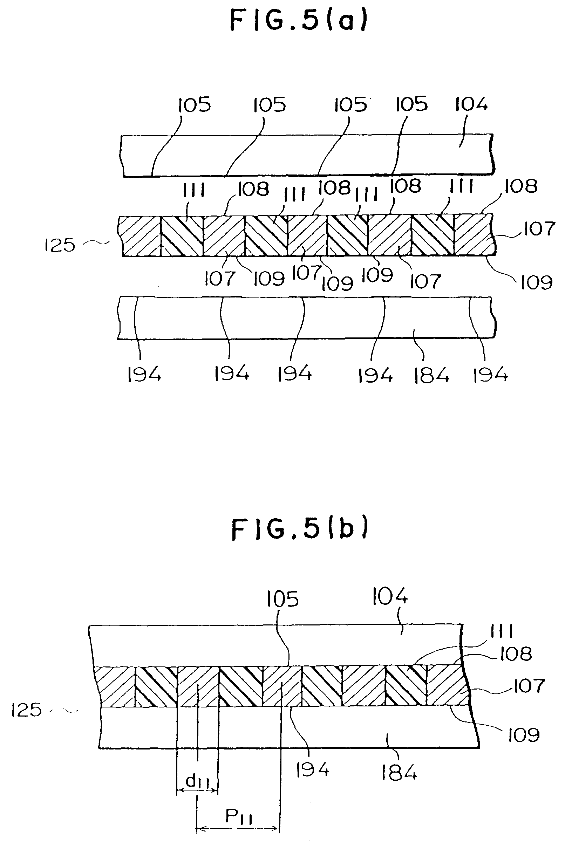

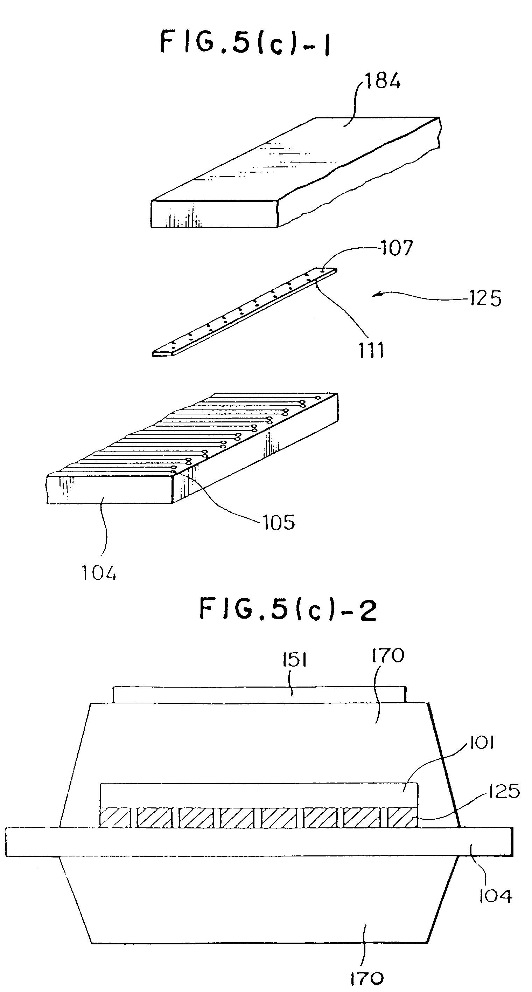

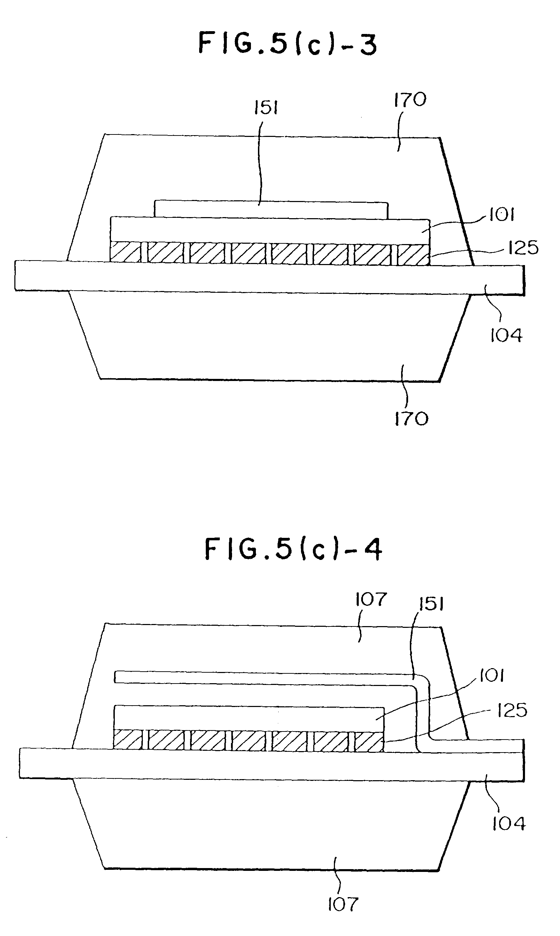

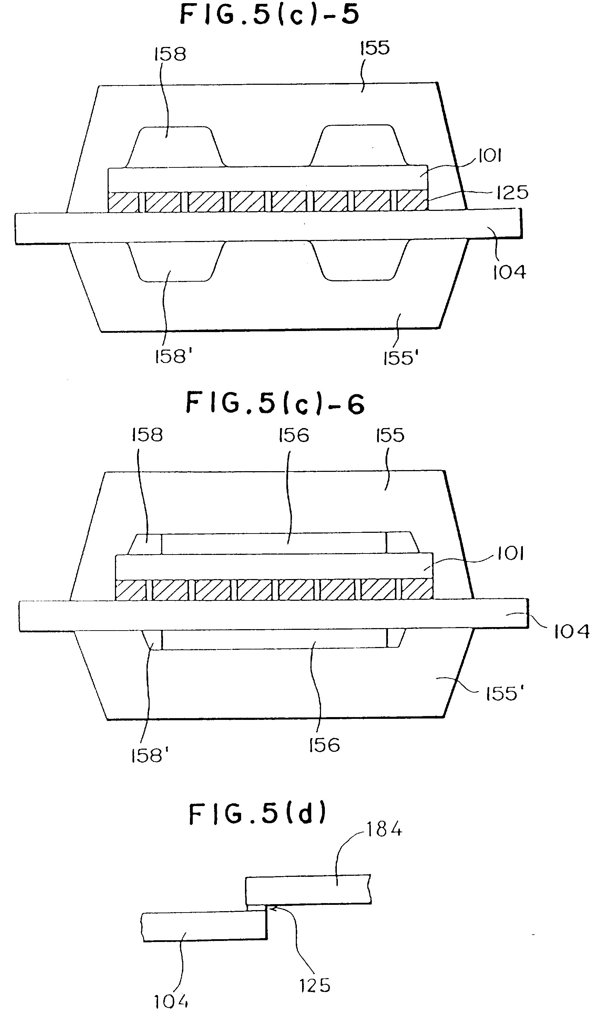

The Example 1-D1 of the present invention will be explained according to FIGS. 5(a), 5(b), 5(c)-1 and 6.

An electric circuit device of the present embodiment at least comprises an electric connecting member 125 comprising a support member 111 consisting of an organic material and metal members 107 which are plural electrically conductive members buried within the support member 111, one ends of the metal members 107 being exposed at one surface of the support member 111, and another ends of the metal members 107 being exposed at another surface of the support member 111;
a circuit substrate 104 comprising connecting regions 105 and connected to one ends of the metal members 107 exposed at one surface of the support member 111 at the connecting regions 105;
a circuit substrate 184 comprising connecting regions 194 and connected to another ends of the metal members 107 exposed at another surface of the support member 111 at the connecting regions 194. The metal members 107 exposed at both surfaces of the support member 111 are arranged in a zigzag form, and the metal members 107 have a wave-like form.

The present embodiment will be hereinafter explained in detail.

First, the electric connecting member 125 will be explained illustrating a production method of the electric connecting member 125.

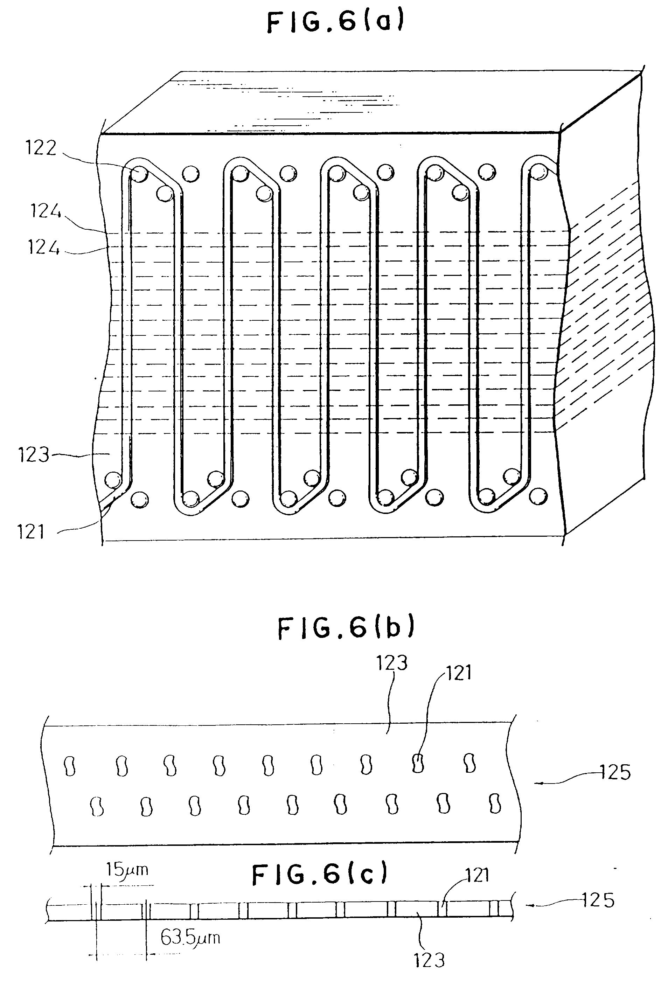

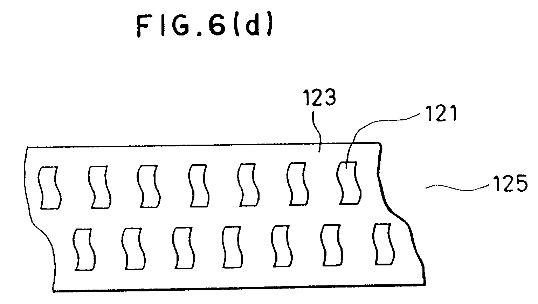

FIG. 6 shows an example of the production method.

First, as shown in FIG. 6(a), a metal wire 121 consisting of a metal, such as gold, or an alloy having a wave-like form and a thickness of 30 µmφ at maximum is wound around rods 122 at a pitch of 63.5 µm in a zigzag form. After having been wound, the metal wire is buried in a resin 123, such as polyimide. After having been buried, the resin 123 is hardened. The hardened resin 123 becomes an insulator. Subsequently, the resultant body is sliced at positions 124 to prepare the electric connecting members 125. The electric connecting member 125 thus prepared is shown in FIGS. 6(b), 6(c) and 6(d). The thickness and shape of the metal wires in FIG. 6(d) is different from those of the metal wires in FIGS. 6(b) and 6(c).

In the electric connecting member 125 thus prepared, the metal wires 121 constitute the metal members 107, and the resin 123 constitutes the support member (insulator) 111.

In the electric connecting member 125, the metal wires as the metal members are insulated from one another by the resin 123. One ends of the metal wires 121 are exposed at the side of the circuit substrate 104, and another ends are exposed at the side of the circuit substrate 184. The exposed portions are connected to the connecting regions 105 of the circuit substrate 104 and the connecting regions 194 of the circuit substrate 184, respectively.

Next, as shown in FIGS. 5(a) and 5(c), the circuit substrate 104, the electric connecting member 125 and the circuit substrate 184 are prepared. The circuit substrates 104 and 184 used in the present embodiment have many connecting regions 105 and 194 in respective inner portion.

At the connecting regions 105 of the circuit substrate 104, a metal is exposed at positions corresponding to the connecting regions 194 of the circuit substrate 184 and the connecting regions 108 and 109 of the electric connecting member 125.

A locating is performed so that the connecting regions 105 of the circuit substrate 104 and the connecting regions 108 of the electric connecting member 125, or the connecting regions 194 of the circuit substrate 184 and the connecting regions 109 of the electric connecting member 125 correspond to one another. After the locating, Au on the connecting regions 105 of the circuit substrate 104 and Au on the connecting regions 108 of the electric connecting member 125, and Au on the connecting regions 194 of the circuit substrate 184 and Au on the connecting regions 109 of the electric connecting member 125 are connected together (FIGS. 5(b) and 5(d)).

In the present embodiment, connection by pressing is performed, but connection may also be performed by interdiffusion of metals and/or alloying two surfaces or one surface of the electric connecting member.

In order to connect together the circuit substrate 104, the electric connecting member 125 and the circuit substrate 184 by interdiffusion of metals and/or alloy formation, there are the following three methods. Any of these methods may be used.
1) A method in which, after locating the circuit substrate 104, the electric connecting member 125 and the circuit substrate 184 to one another, the connecting regions 105 of the circuit substrate 104 and the connecting regions 108 of the electric connecting member 125, and the connecting regions 194 of the circuit substrate 184 and the connecting regions 109 of the electric connecting regions 125 are connected together by interdiffusion of metals and/or alloy formation.
2) A method in which, after locating the circuit substrate 104 and the electric connecting member 125 to each other, the connecting regions 105 of the circuit substrate 104 and the connecting regions 108 of the electric connecting member 125 are connected together by interdiffusion of metals and/or alloy formation, and the circuit substrate 184 is then located, and the connecting regions 109 of the electric connecting member 125 and the connecting regions 194 of the circuit substrate 184 are connected together by interdiffusion of metals and/or alloy formation.
3) A method in which, after locating the circuit substrate 184 and the electric connecting member 125 to each other, the connecting regions 194 of the circuit substrate 184 and the connecting regions 109 of the electric connecting member 125 are connected together by interdiffusion of metals and/or alloy formation, and the circuit substrate 104 is then located, and the connecting regions 108 of the electric connecting member 125 and the connecting regions 105 of the circuit substrate 104 are connected together by interdiffusion of metals, and/or alloy formation.

For electric circuit devices prepared as described above, connectability of their connecting regions was investigated, and it was confirmed that they are connected together with a high reliability.

Moreover, reliability of various characteristics was excellent.

### EXAMPLE 1-D2

FIG. 5(c)-2 shows Example 1-D2.

In the present embodiment, a plate 151 made of stainless steel and having a thickness of 0.1 mm is connected by being sticked to the surface of a sealant 170 at one side in the case of Example 1-D1.

Other conditions are identical to those in Example 1-D1.

### EXAMPLE 1-D3

FIG. 5(c)-3 shows Example 1-D3.

In the present embodiment, a plate 151 made of stainless steel and having a thickness of 0.1 mm is connected by being sticked to the surface opposite to the electric connecting member 125 of a semiconductor device 101 in the case of Example 1-D1. In the present embodiment, the plate 151 is connected only to the semiconductor device 101.

Other conditions are identical to those in Example 1-D1.

### EXAMPLE 1-D4

FIG. 5(c)-4 shows Example 1-D4.

In the present embodiment, a plate 151 made of stainless steel and having a thickness of 0.1 mm is disposed at near a semiconductor device 101 in the case of Example 1-D1.

Other conditions are identical to those in Example 1-D1.

### EXAMPLE 1-E1

FIG. 5(c)-5 shows Example 1-E1.

In the present embodiment, a semiconductor device 101 and the circuit substrate 104 are both subjected to cap sealing in the case of Example 1-D1. For caps, as shown in FIG. 5(c)-5, caps 155 and 155' each having two recesses in its inner portions are used. Recessed portions of the caps form hollow portions 158 and 158', and protruded portions of the caps contact the back surfaces of the semiconductor device 101 and the circuit substrate 104. The semiconductor device 101 and the circuit substrate 104 are firmly held to the electric connecting member 125.

In the present embodiment, the caps 155 and 155' are connected together by an adhesive.

Other conditions are identical to those in Example 1-D1.

### EXAMPLE 1-E2

FIG. 5(c)-6 shows Example 1-E2.

In the present embodiment, members for adjustment are provided between the semiconductor device 101 and the cap 156, and between the circuit substrate 104 and the cap 156 and, cap sealing is then performed in the case of Example 1-E1.

Other conditions are identical to those in Example 1-E1.

### EXAMPLE 2-D1

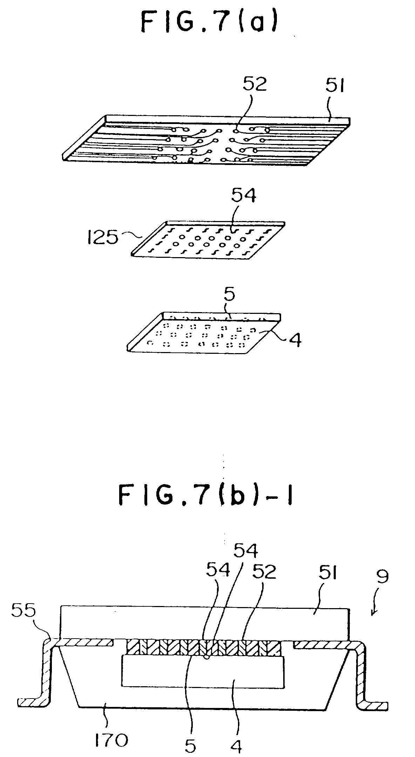

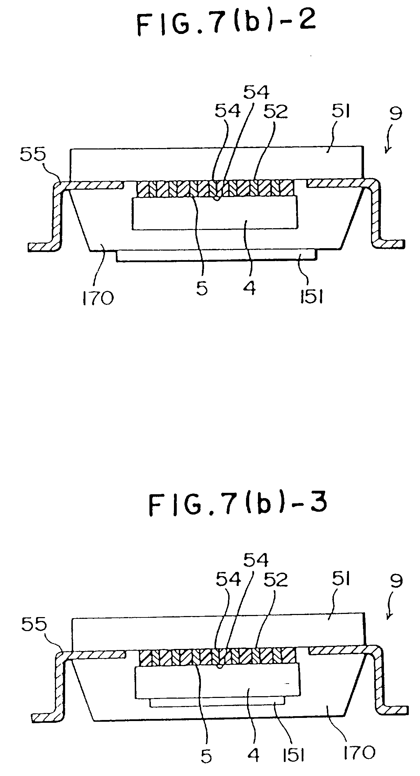

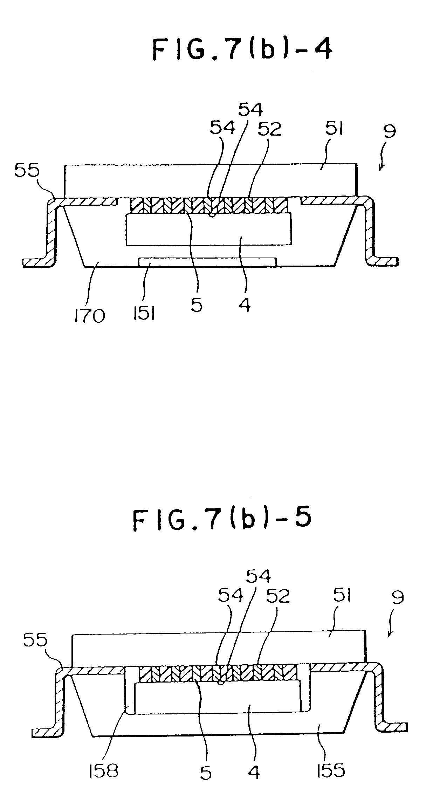

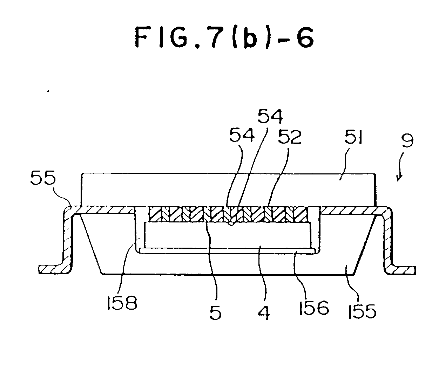

FIGS. 7(a) and 7(b)-1 show Example 2-D1.

In the present embodiment, among metal wires 54 of the electric connecting member, those at outer circumferential portions were made to have an S-like shape. Metal wires at inner portions of the support member were made to have a circular shape. A circuit substrate 51 was used as a first electric circuit component having connecting regions 52, and a semiconductor device 4 having many connecting regions 5 in its inner portions was used as a second electric circuit component.

In the present embodiment, the electric connecting member 125 in which a powder consisting of SiO₂ (not illustrated) is dispersed within the support member consisting of an organic material was used.

Furthermore, in the present embodiment, the connecting regions 54 of this electric connecting member and the connecting regions 52 of the circuit substrate 51 were connected together by interdiffusion of metals, and/or alloy formation. On the other hand, the electric connecting member 125 and the semiconductor device 4 were connected together by a connection method other than interdiffusion of metals, and/or alloy formation. That is, the semiconductor device 4 was pressed to the electric connecting member 125 and temporarily held by an adhesive, and sealing was then performed from thereon.

The electric connecting member 125 having a size which corresponds to that of the semiconductor device 4 was used.

In the present embodiment, a lead frame 55 was connected to the lower surface of the circuit substrate 51.

Furthermore, In the present embodiment, only the semiconductor device 4 was sealed. A sealant in which a powder consisting of SiO₂ is dispersed in a thermoplastic resin was used.

Other conditions are identical to those in Example 1-D1.

In the present embodiment as well, the connecting regions were connected with a high reliability.

Furthermore, reliability of various characteristics was excellent.

### EXAMPLE 2-D2

FIG. 7(b)-2 shows Example 2-D2.

In the present embodiment, a plate made of stainless steel and having a thickness of 0.1 mm is connected by being sticked on a surface of a sealant 170 in the case of Example 2-D1.

Other conditions are identical to those in Example 2-D1.

### EXAMPLE 2-D3

FIG. 7(b)-3 shows Example 2-D2.

In the present embodiment, a plate 151 made of stainless steel and having a thickness of 0.1 mm is connected by being sticked to the surface opposite to the electric connecting member 125 of the semiconductor device 4 in the case of Example 2-D1. In the present embodiment, the plate 151 is connected only to the semiconductor device 4.

Other conditions are identical to those in Example 2-D1.

### EXAMPLE 2-D4

FIG. 7(b)-4 shows Example 2-D4.

In the present embodiment, a plate 151 made of stainless steel and having a thickness of 0.1 mm is disposed in the vicinity of the semiconductor device 4 in the case of Example 2-D1. In the present embodiment, sealing is performed except a surface of the plate 151, that surface being exposed to the outside.

Other conditions are identical to those in Example 1-D1.

### EXAMPLE 2-E1

FIG. 7(b)-5 shows Example 2-E1.

In the present embodiment, the semiconductor device 4 was subjected to cap sealing by a cap 155 in the case of Example 2-D1.

As shown in FIG. 7(b)-5, the cap 155 having a recess in its inner portion is used. Using the cap 155, cap sealing is performed so that hollow portions 158 are formed at both sides of the semiconductor device 4. In the present embodiment, only the semiconductor device 4 is subjected to cap sealing.

Other conditions are identical to those in Example 2-D1.

### EXAMPLE 2-E2

FIG. 7(b)-6 shows Example 2-E2.

In the present embodiment, a member 156 for adjustment is provided between the semiconductor device 4 and the cap 155 and cap sealing is then performed in the case of Example 1-E1.

Other conditions are identical to those in Example 1-E1.

### EXAMPLE 3-D1

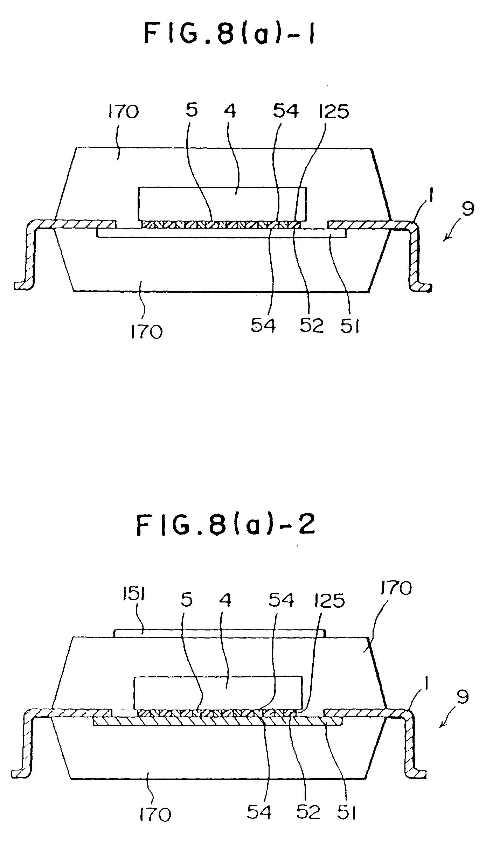

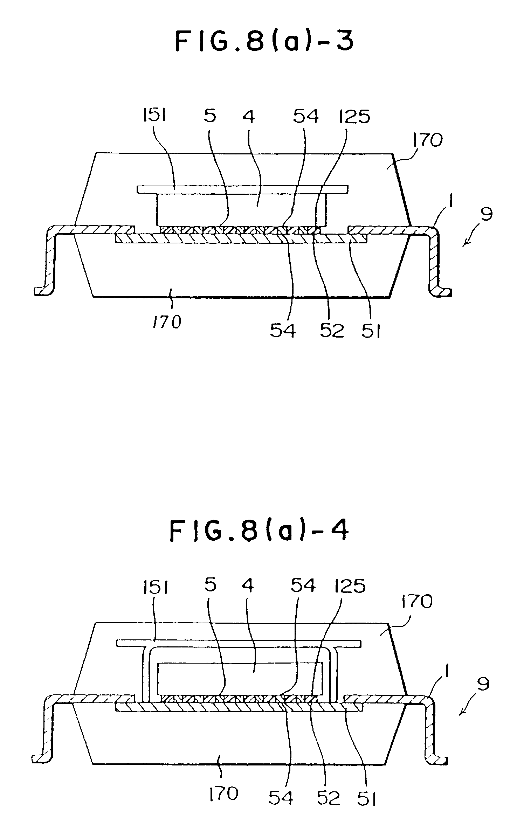

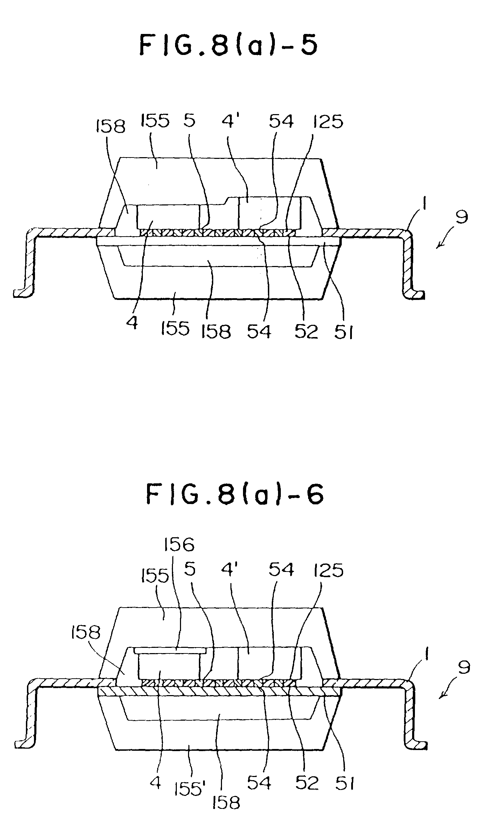

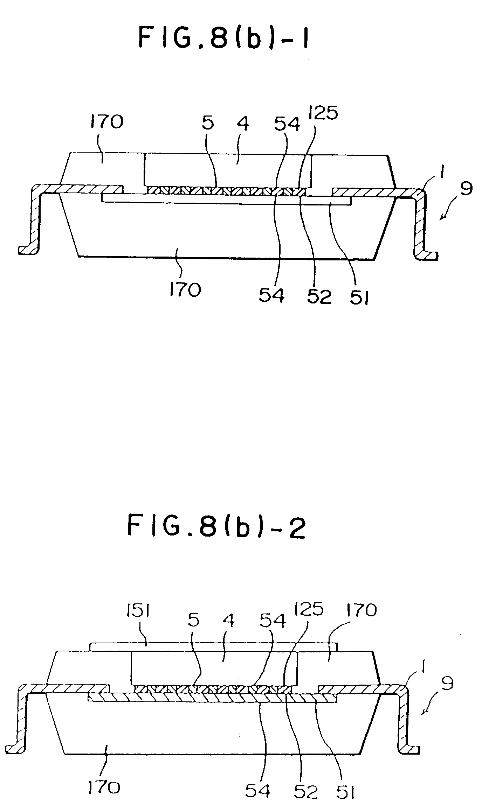

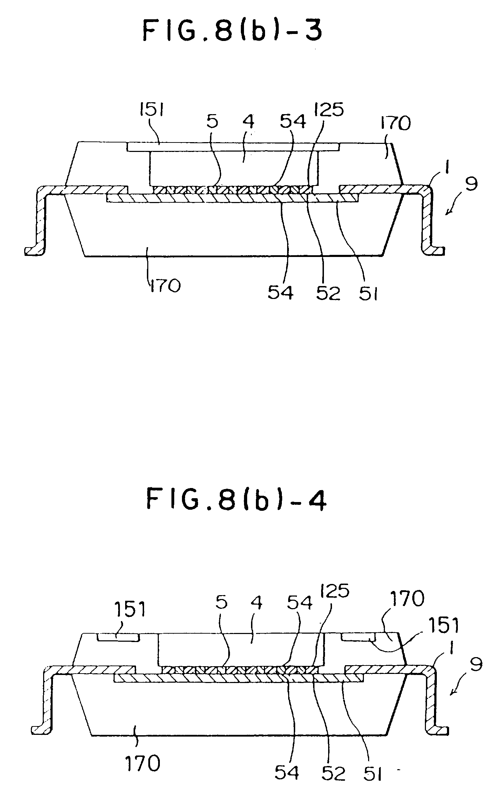

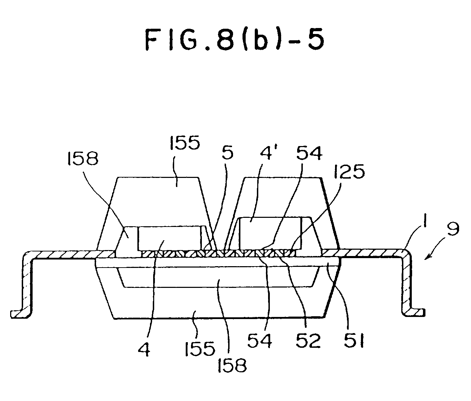

FIGS. 8(a)-1 and 8(b)-1 show Example 3-D1.

The present embodiment is an example in which a first electric circuit component is the semiconductor device 4, and a second electric circuit component is the circuit substrate 51.

After connection, a lead frame 1 was connected on the upper surface of the circuit substrate 51. The electric circuit member was then set within a cavity of a mold, and injection molding was performed to form the sealant 170.

FIG. 8(a)-1 is an example in which the semiconductor device 4 was totally buried by the sealant, and FIG. 8(b)-1 is an example in which the upper surface of the semiconductor device 4 was exposed to the outside, and side portions of the device were buried by a sealant.

Other conditions are identical to those in Example 1-D1.

In the present embodiment as well, connecting regions were connected with a high reliability.

Furthermore, reliability of various characteristics was also excellent.

### EXAMPLE 3-D2

FIG. 8(a)-2 shows Example 3-2D.

In the present embodiment, a plate 151 made of stainless steel and having a thickness of 0.1 mm is connected by being sticked to a surface of the sealant 170 at one side in the case of Example 3-D1.

Other conditions are identical to those in Example 3-D1.

FIG. 8(b)-2 shows a modified example of Example 3-D2.

In the present modified example, one sheet of a plate 151 was connected by being sticked to a surface of the sealant 170 and the exposed surface of the semiconductor device 4 in the case of the modified example of Example 3-D1.

Other conditions are identical to those in the modified example of Example 3-D1.

### EXAMPLE 3-D3

FIG. 8(a)-3 shows Example 3-D3.

In the present embodiment, a plate 151 made of stainless steel and having a thickness of 0.1 mm is connected by being sticked to the surface opposite to the electric connecting member 125 of the semiconductor device 4 in the case of Example 3-D1.

Other conditions are identical to those in Example 3-D1.

FIG. 8(b)-3 shows a modified example of Example 3-D3.

In the present modified example, the plate 151 is connected by being sticked to the exposed surface of the semiconductor device 4 in the case of the modified example of Example 3-D1. The surface opposite to the semiconductor device of the plate 151 is exposed to the outside.

Other conditions are identical to those in the modified example of Example 3-D1.

### EXAMPLE 3-D4

FIG. 8(a)-4 shows Example 3-D4.

In the present embodiment, an assembled body of plates 151 made of stainless steel and having a thickness of 0.1 mm is disposed at near the semiconductor device 4 in the case of Example 3-D1. In the present embodiment, the assembled body of plates 151 is disposed so that it encloses surroundings of the semiconductor device 4.

Other conditions are identical to those in Example 3-D1.

FIG. 8(b)-4 shows a modified example of Example 3-D4.

In the present modified example, plates 151 are disposed at both sides of the semiconductor device 4, respectively, in the case of the modified example of Example 3-D1. One surface of each plate 151 is exposed to the outside.

Other conditions are identical to those in the modified example of Example 3-D1.

### EXAMPLE 3-E1

FIG. 8(a)-5 shows Example 3-E1.

In the present embodiment, two semiconductor devices 4 and 4' are provided the heights of which are different from each other, and these two semiconductor devices 4 and 4' are subjected to cap sealing.

As shown in FIG. 8(a)-5, a cap 155 having a stepped recess in its inner portion is used. Using the cap 155, cap sealing is performed so that hollow portions 158 are formed at both sides of the semiconductor devices 4 and 4'.

Other conditions are identical to those in Example 3-D1.

FIG. 8(b)-5 shows a modified example of Example 3-E1.

In the present modified example, the semiconductor devices 4 and 4' are separately subjected to cap sealing.

Other conditions are identical to those in the present embodiment.

### EXAMPLE 3-E2

FIG. 8(a)-6 shows Example 3-E2.

In the present example, a member 156 for adjustment is provided between the semiconductor device 4 and the cap 156 and cap sealing is then performed in the case of Example 3-E1.

Other conditions are identical to those in Example 3-E1.

### EXAMPLE 4-D1

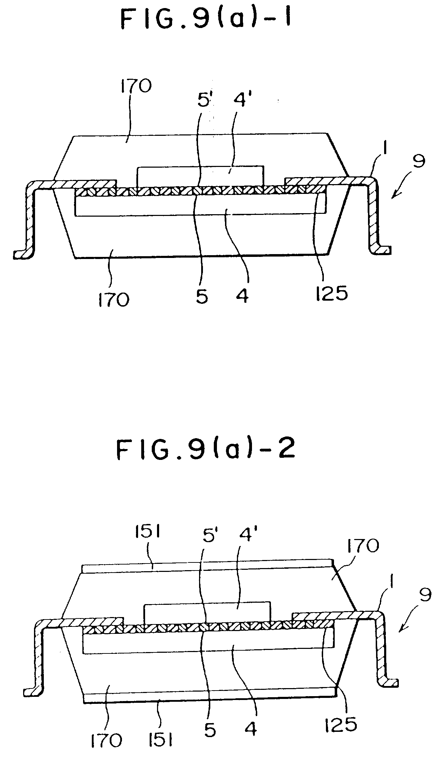

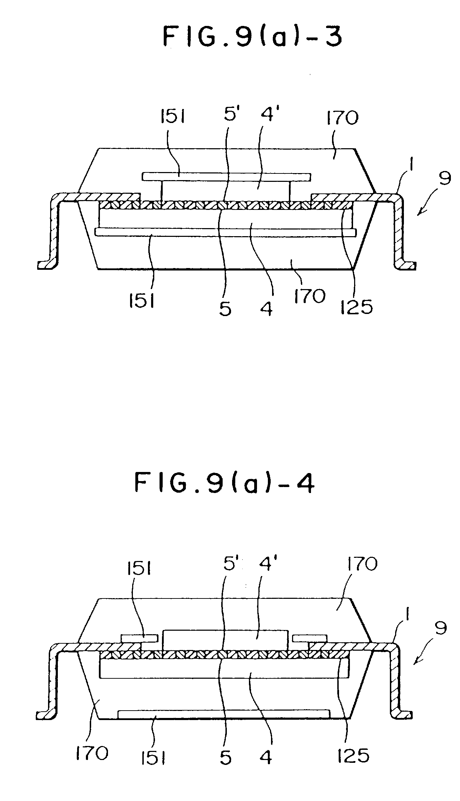

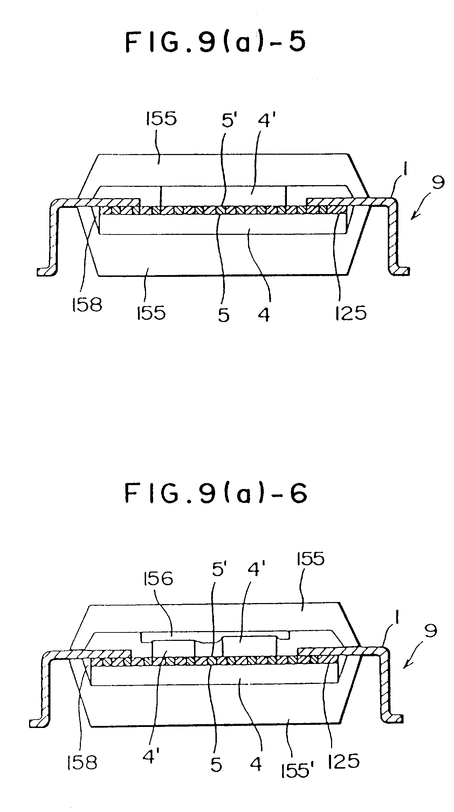

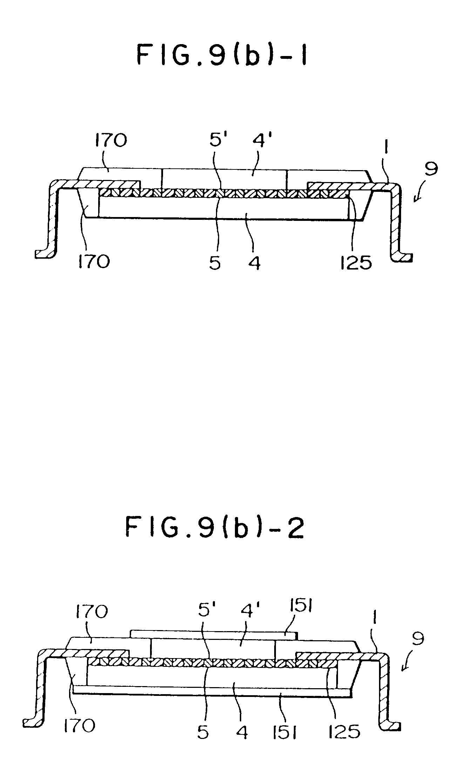

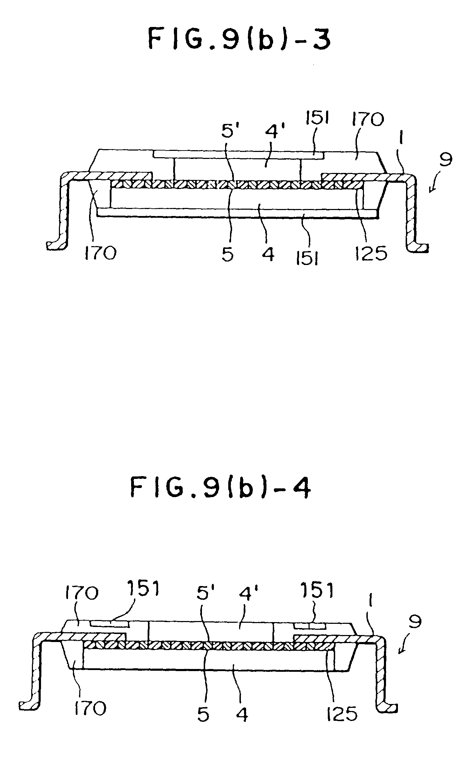

FIG. 9(a)-1 shows Example 4-D1.

The present embodiment is an example in which a first electric circuit component is the semiconductor device 4', and a second electric circuit component is the semiconductor device 4. In the present embodiment, an electric connecting member the size of which corresponds to that of the semiconductor device 4 is used, and a lead frame 1 is connected to a metal member exposed at the side of the first semiconductor device 4' of the electric connecting member 125.

As an insulator for the electric connecting member 125, an organic material, in which one or both of a metal powder and metal fibers are dispersed, was used. Furthermore, FIG. 9(b)-1 shows a case in which both devices are not connected by interdiffusion of metals and/or alloy formation. When sealing, sealing is performed pressing the semiconductor devices 4 and 4' (not illustrated).

It is to be noted that FIG. 9(a)-1 is a case in which the semiconductor devices 4 and 4' are totally buried by a sealant, and FIG. 9(b)-1 is a case in which the upper surfaces of the semiconductor devices 4 and 4' are exposed to the outside, and side portions of the devices are buried by a sealant.

Other conditions are identical to those in Example 3-D1.

In the present embodiment as well, connecting regions were connected with a high reliability.

Furthermore, reliability in various characteristics was also excellent.

### EXAMPLE 4-D2

FIG. 9(a)-2 shows Example 4-D2.

In the present embodiment, a plate 151 made of stainless steel and having a thickness of 0.1 mm is connected by being sticked to surfaces of sealants 170 at both sides in the case of Example 4-D1.

Other conditions are identical to those in Example 4-D1.

FIG. 9(b)-2 shows a modified example of Example 4-D2.

In the present modified example, one sheet of plate 151 is connected by being sticked to a surface of the sealant 170 and the exposed surface of the semiconductor device 4', and one sheet of plate 151 is also connected by being sticked to a surface of the sealant 170 and the exposed surface of the semiconductor device 4.

Other conditions are identical to those in the modified example of Example 4-D1.

### EXAMPLE 4-D3

FIG. 9(a)-3 shows Example 4-D3.

In the present embodiment, a plate 151 made of stainless steel and having a thickness of 0.1 mm is connected by being sticked to the surface opposite to the electric connecting member 125 of the semiconductor device 4, and a plate made of stainless steel having a thickness of 0.1 mm is connected by being sticked to the surface opposite to the electric connecting member 125 of the semiconductor device 4' in the case of Example 4-D1.

Other conditions are identical to those in Example 4-D1.

FIG. 9(b)-3 shows a modified example of Example 4-D3.

In the present modified example, a plate 151 is connected by being sticked to the exposed surface of the semiconductor device 4, and a plate 151 is also connected by being sticked to the exposed surface of the semiconductor device 4. Surfaces of the plates 151 opposite to the semiconductor devices 4 and 4' are exposed to the outside.

Other conditions are identical to those in the modified example of Example 4-D1.

### EXAMPLE 4-D4

FIG. 9(a)-4 shows Example 4-D4.

In the present embodiment, plates 151 made of stainless steel and having a thickness of 0.1 mm are disposed at near both sides of the semiconductor devices 4', respectively, and a plate 151 is also disposed at near the semiconductor device 4. One surface of the plate 151 disposed at near the semiconductor device 4 is exposed to the outside.

Other conditions are identical to those in Example 4-D4.

FIG. 9(b)-4 shows a modified example of Example 4-D4.

In the present modified example, plates 151 are disposed at both sides of the semiconductor device 4', respectively, in the case of the modified example of Example 4-D1. One surface of each plate 151 is exposed to the outside.

Other conditions are identical to those in Example 4-D1.

### EXAMPLE 4-E1

FIG. 9(a)-5 shows Example 4-E1.

In the present embodiment, the semiconductor devices 4 and 4' are subjected to cap sealing, respectively, in the case of Examle 4-D1.

Other conditions are identical to those in Example 4-D1.

### EXAMPLE 4-E2

FIG. 9(a)-6 shows Example 4-E2.

In the present embodiment, a member 156 for adjustment having steps is disposed between semiconductor devices 4' and 4' having different heights and a cap 155, and cap sealing is then performed in the case of Example 4-E1.

Other conditions are identical to those in Example 4-E1.

### EXAMPLE 5

FIG. 10 shows Example 5.

Example 5 is an example in which circuit substrates 101 and 104, portions other than connecting regions of which are covered with insulating films 103 and 106, are used as a first circuit component and a second circuit component.

An electric connecting member as shown in FIG. 11 was used. That is, in the electric connecting member 125 shown in FIG. 11, a part of its metallic members 107 (metal wires 121) is arranged in a zigzag form, and exposed portions of the metal members 107 protrude from the surfaces of the support member (resin insulator) 111. Such an electric connecting member 125 may be produced, for example, by the following method.

First, by the method described in Example 1-D1, the electric connecting member shown in FIGS. 6(b) and 6(c) is prepared. Next, the both sides of the electric connecting member may be etched until the metal wires 121 protrude about 10 µm from the polyimide resin 123.

Although the amount of protrusion is made to be 10 µm in the present embodiment, any amount may also be selected.

Furthermore, the method for protruding the metal wires 121 is not limited to etching, but other chemical or mechanical methods may also be used.

Other conditions are identical to those in Example 1-D1.

Relative to protrusion, bumps 150 as shown in FIG. 12 may also be formed by pinching the electric connecting member 125 in a mold having recesses at positions of the metal wires 121, and crushing protrusions 126 of the metal wires 121. In this case, the metal wires 121 hardly leave from the insulator 111.

It is to be noted that the metal wires 121 constitute the metal members 107, and the resin 123 constitutes the insulator 111.

The bumps may also be formed by fusing the protrusions by heat, or by any other methods.

In the present embodiment as well, the connecting regions were connected with a high reliability.

Furthermore, reliability in various characteristics was excellent.

### EXAMPLE 6-D1

FIGS. 13(a) and 13(b)-1 show Example 6-D1.

The present embodiment is an example in which a semiconductor device 4 was used as a first electric circuit component and a lead frame 1 was used as a second electric circuit component.

In the present embodiment, ends of the metal members 107 have an S-like form.

Connecting regions 6 of the lead frame 1 made of 42-alloy on the surface of which Ag is plated were used. Connection was performed by a thermocompression method in which both ultrasonic heating and external heating were utilized.

Other conditions are identical to those in Example 5.

In the present embodiment as well, connecting regions were connected with a high reliability.

Furthermore, reliability in various characteristics was also excellent.

### EXAMPLE 6-D2

FIG. 13(b)-2 shows Example 6-D2.

In the present embodiment, a plate made of stainless steel and having a thickness of 0.1 mm and holes 152 is connected by being sticked to a surface of the sealant 170 at one side in the case of Example 6-D1.

Other conditions are identical to those in Example 6-D1.

### EXAMPLE 6-D3

FIG. 13(b)-3 shows Example 6-D3.

In the present embodiment, a plate 151 made of stainless steel and having a thickness of 0.1 mm and holes 152 is connected by being sticked to the surface opposite to the electric connecting member 125 of the semiconductor device 4 in the case of Example 6-D1.

Other conditions are identical to those in Example 6-D1.

### EXAMPLE 6-D4

FIG. 13(b)-4 shows Example 6-D4.

In the present embodiment, a plate 151 made of stainless steel and having a thickness of 0.1 mm which is bent at a nearly right angle is disposed at near the semiconductor device 4 in the case of Example 6-D1.

Other conditions are identical to those in Example 6-D1.

### EXAMPLE 6-E1

FIG. 13(b)-5 shows Example 6-E1.

In the present embodiment, each of the semiconductor device 4 and the lead frame 1 is subjected to cap sealing.

Other conditions are identical to those in Example 5-D1.

### EXAMPLE 6-E2

FIG. 13(b)-6 shows Example 6-E2.

In the present embodiment, a member 156 for adjustment is disposed between the semiconductor device 4 and the cap 155 and cap sealing is then performed in the case of Example 6-E1.

Other conditions are identical to those in Example 6-E1.

### EXAMPLE 7

FIG. 14 shows Example 7.

In the present embodiment, the electric connecting member 125 is different from that shown in Example 5. That is, in the electric connecting member 125 of the present embodiment, a pitch between metal members is narrower that that shown in Example 5. That is, in the present embodiment, the pitch between metal members 107 is set at a spacing which is narrower than the spacing between connecting regions of a first circuit substrate.

In Example 5, since connecting positions of the electric connecting member 125 are arranged at connecting positions of the first circuit substrate 101 and the second circuit substrate 104, it is necessary to locate the electric connecting member 125. In the present embodiment, however, although it is necessary to locate the first circuit substrate 101 and the second circuit substrate 104 to each other, it is not necessary to perform locating for the electric connecting member 125. Consequently, by selecting connecting dimensions (d₁₁, P₁₁) of the first circuit substrate 101 and the second circuit substrate 104 and connecting dimensions (d₁₂, P₁₂) of the electric connecting member at proper values, it is also possible to perform connection without performing locating.

Other conditions are identical to those in Example 1-D1.

In the present embodiment as well, connecting regions were connected with a high reliability.

Furthermore, reliability in various characteristics was excellent.

### EXAMPLE 8

Example 8 of the present invention will be explained according to FIG. 15.

An electric circuit device of the present embodiment at least comprises an electric connecting member 125 comprising a support member 111 made of an organic material and metal members 107 which are plural electrically conductive members buried within the support member 111, one ends of the metal members 107 being exposed at one surface of the support member 111, and another ends of the metal members 107 being exposed at another surface of the support member 111;
a circuit substrate 104 comprising connecting regions 105 and connected to one ends of the metal members 107 exposed at one surface of the support member 111 at the connecting regions 105 which exist at end portions of the circuit substrate;
a circuit substrate 184 comprising connecting regions 194 and connected to another ends of the metal members 107 exposed at another surface of the support member 111 at the connecting regions 194 which exist at end portions of the circuit substrate.

The metal members 107 exposed at both surfaces of the support member 111 are arranged in a zigzag form, and the metal members 107 have a wave-like form.

It is to be noted that, in the present embodiment, plural semiconductor devices 101 are connected to the circuit substrate 104.

The electric circuit device of the present embodiment is a device for performing recording utilizing a thermal energy, and the circuit substrate 184 comprises a heating body 400.

The present embodiment will be hereinafter explained in detail.

An example of the production of the eletric connecting member 125 is as explained in Example 1.

As shown in FIGS. 5(a) and 15(a), the circuit substrate 104, the electric connecting member 125 and the circuit substrate 184 are prepared. The circuit substrate 104 and the circuit substrate 184 used in the present embodiment have many connecting regions 105 and 194 at end portions thereof.

At the connecting regions 105 of the circuit substrate 104, a metal is exposed at positions corresponding to the connecting regions 194 of the circuit substrate 184 and the connecting regions 108 and 109 of the electric connecting member 125.

A locating is performed so that the connecting regions 105 of the circuit substrate 104 and the connecting regions 108 of the electric connecting member 125, or the connecting regions 194 of the circuit substrate 184 and the connecting regions 109 of the electric connecting member 125 correspond to one another. After the locating, Au on the connecting regions 105 of the circuit substrate 104 and Au on the connecting regions 108 of the electric connecting member 125, and Au on the connecting regions 194 of the circuit substrate 184 and Au on the connecting regions 109 of the electric connecting member 125 are connected together (FIGS. 5(b) and 15(b)).

In the present embodiment, connection by pressing is performed, but connection may also be performed by interdiffusion of metals, and/or alloying two surfaces or one surface of the electric connecting member. Connection may, of course, be performed using an adhesive.

In order to connect together the circuit substrate 104, the electric connecting member 125 and the circuit substrate 184 by interdiffusion of metals, and/or alloy formation, there are the following three methods. Any of these methods may be used.
1) A method in which, after locating the circuit substrate 104, the electric connecting member 125 and the circuit substrate 184 to one another, the connecting regions 105 of the circuit substrate 104 and the connecting regions 108 of the electric connecting member 125, and the connecting regions 194 of the circuit substrate 184 and the connecting regions 109 of the electric connecting regions 125 are connected together by interdiffusion of metals and/or alloy formation.
2) A method in which, after locating the circuit substrate 104 and the electric connecting member 125 to each other, the connecting regions 105 of the circuit substrate 104 and the connecting regions 108 of the electric connecting member 125 are connected together by interdiffusion of metals and/or alloy formation, and the circuit substrate 184 is then located, and the connecting regions 109 of the electric connecting member 125 and the connecting regions 194 of the circuit substrate 184 are connected together by interdiffusion of metals and/or alloy formation.
3) A method in which, after locating the circuit substrate 184 and the electric connecting member 125 to each other, the connecting regions 194 of the circuit substrate 184 and the connecting regions 109 of the electric connecting member 125 are connected together by interdiffusion of metals, and/or alloy formation, and the circuit substrate 104 is then located, and the connecting regions 108 of the electric connecting member 125 and the connecting regions 105 of the circuit substrate 104 are connected together by interdiffusion of metals and/or alloy formation.

In this case, if it is arranged so that the melting point of an alloy layer at the connecting regions 108 is different from that of an alloy layer at the connecting regions 109, it is possible to remove connecting regions having a lower melting point if necessary. For example, a solder having a eutectic composition in which Sn:Pb weight ratio is 61.9%:38.1% may be used for the connecting regions 108, and a solder having a eutectic composition in which Sn:Pb weight ratio is 5%:95% may be used for connecting regions 109.

For electric circuit devices produced as described above, connectability of their connecting regions was investigated, and it was confirmed that they were connected with a high reliability.

Furthermore, reliability in various characteristics was also excellent.

### EXAMPLE 9

FIG. 16 shows Example 9.

The present embodiment is an example in which the electric circuit device is an ink-jet recording head utilizing a thermal energy. The circuit substrate 184 includes an ink room 401. A pitch of the connecting regions 105 and 194 of the circuit substrates 104 and 184 is 63.5 µm.

The configuration of the electric connecting member 125 is different from that in FIG. 10 as will be described below.

That is, in the electric connecting member 125 of the present embodiment, a pitch between metal members is narrower than that shown in Example 8. That is, in the present embodiment, a pitch between the metal members 107 is set at a spacing which is narrower than the spacing in the connecting member 105 and 194 of the circuit substrates 104 and 184.

In Example 8, since connecting positions of the electric connecting member 125 are arranged at connecting positions of the circuit substrate 104 and the circuit substrate 184, it is necessary to locate the electric connecting member 125. In the present embodiment, however, although it is necessary to locate the circuit substrate 104 and the circuit substrate 184 to each other, it is not necessary to perform locating for the electric connecting member 125. Consequently, by selecting connecting dimensions (d₁₁, P₁₁) of the circuit substrate 104 and the circuit substrate 184 and connecting dimensions (d₁₂, P₁₂) of the electric connecting member at proper values, it is also possible to perform connection without performing locating.

For electric circuit devices produced as described above, connectability of their connecting regions was investigated, and they were connected with a high reliability.

Furthermore, reliability in various characteristics was also excellent.

### EXAMPLE 10

In the present embodiment, electric connecting members shown in FIGS. 17 and 18 were used.

That is, in the electric connecting member 125 shown in FIG. 17, a part of its metal members 107 (metal wires 121) is arranged in a zigzag form, and exposed portions of the metal members 107 are protruded from the surfaces of the support member 111 (resin insulator). Such an electric connecting member 125 may, for example, be produced by the following method.

First, by the method described in Example 8, the electric connecting member shown in FIGS. 6(b) and 6(c) are prepared. The both surfaces of the electric connecting member may then be etched until the metal wires 121 protrude about 10 pm from the polyimide resin 123.

Although the amount of protrusion is made to be 10 µm in the present embodiment, any amount may also be selected.

The method for protruding the metal wires 121 is not limited to etching, but other chemical or mechanical methods may also be used.

Other conditions are identical to those in Example 8.

Relative to protrusions, bumps 150 as shown in FIG. 5 may also be formed by pinching the electric connecting member 125 in a mold having recesses at positions of the metal wires 121, and crushing protrusions 126 of the metal wires 121. In this case, the metal wires 121 hardly leave from the insulator 111.

It is to be noted that the metal wires 121 constitute the metal members 107, and the resin 123 constitutes the insulator 111.

The bumps may also be produced by fusing the protrusions by heat, or by any other methods.

Connection in the present embodiment was performed in the following way. That is, an adhesive was coated on at least a part of either one of the circuit substrates 104 and 184, and the electric connecting member and the circuit substrate were sticked together. Excessive adhesive existing at the connecting regions and the support member 111 was then forced out by applying a force, the metal members 107 of the electric connecting member 125 and the connecting regions 105 and 194 of the circuit substrates 104 and 184 were connected together, and the adhesive was hardened.

### EXAMPLE 11

FIG. 19 shows Example 11.

In the present embodiment, the circuit substrates 104 and 184 were connected using two sheets of the electric connecting members 125.

In the present embodiment, the circuit substrates 104 and 184 having many interconnection patterns (connecting regions) 105 and 194 at end portions thereof were used. In the present embodiment, the electric connecting members 125 were bridged between the circuit substrates 104 and 184 to connect the circuit substrates 104 and 184 at the lower surface in the drawing. Another circuit substrate 187 was also connected to the electric conneting member 125 at the upper surface in the drawing to perform electric connection to the circuit substrate 104 and the circuit substrate 184.

Other conditions are identical to those in Example 9.

### EXAMPLE 12

FIG. 20 shows Example 12.

In the present embodiment, on sheet of the electric connecting member 125 was used, and plural semiconductor devices 201, 202, 203 and 204 were used instead of the circuit substrate 187 in the case of Example 11. That is, in the present embodiment, it is intended that the semiconductor devices 201, 202, 203 and 204 have the function of electric connection as well as the function as semiconductor devices.

In the present embodiment, it is possible to reduce the number of interconnection patterns in the circuit substrate 104 by taking in input electric signals from the circuit substrate 104. Accordingly, the present embodiment also has the advantages that an inexpensive circuit substrate can be provided, and connection can be performed without performing an exact locating.

### EXAMPLE 13

FIG. 21 shows Example 13.

In the present embodiment, semiconductor devices 201, 202 and 203 are connected to the circuit substrate 104 via the electric connecting member 125, and semiconductor devices 204 and 205 are connected to the circuit substrate 184 via the electric connecting members 125 and 128.

The circuit substrate 104 and the semiconductor devices 201, 202 and 203, and the circuit substrate 184 and the semiconductor device 204 are connected together by interdiffusion of metals and/or alloy formation using a solder, respectively. It is arranged so that the melting points of metallized layers or alloyed layers at two surfaces of the electric conneting member are different to each other.

For producing such an electric connecting member, a solder is applied on both surfaces of the electric connecting member 125 shown in FIGS. 6(b) and 6(c) by plating. A eutectic solder (Sn:Pb = 61.9 wt %:38.1 wt %) is plated on one surface of the electric connecting member, and a solder having a composition of Sn:Pb = 5 wt %:95 wt % is plated on another surface. In the present embodiment, the latter solder was applied on the side of the circuit substrate 104. In order to remove a semiconductor device, the assembly may be heated at a temperature between the melting points of the two solders.

It is to be noted that the semiconductor device 205 is connected by pressing, and is removable without heating.

The semiconductor device 204 mounted to the circuit substrate 184 is sealed by a sealant 170.

For electric circuit devices produced as described above, connectability of their connecting regions was investigated, and they were connected with a high reliability.

Furthermore, reliability in various characteristics was also excellent.

According to the present invention, since it is possible to dispose connecting regions of an electric circuit component at any positions (especially at inner portions or end portions) in high density, a connection having more points than those in the TAB method becomes possible. Hence, the present invention is a method which is suitable for a connection having multiple pin numbers. Furtheremore, since an insulating material previuosly exists between adjacent metals of an electric connecting member, electric conduction between adjacent metals does not occur even if a pitch between adjacent metals is narrrowed. Hence, a connection having points still more than those in the CCB method becomes possible.

Since the amount of metal members used for an electric connecting member is smaller than that in conventional cases, the electric connecting member becomes less expensive even if an expensive metal, such as gold, is used.

It is possible to provide an electric circuit device, such as a high-density semiconductor device.

In the present invention, since electrically conductive members exposed from a support member of an electric connecting member are arranged in a zigzag form, and an area occupied by connecting regions is larger than that of an interconnection pattern in an electric circuit component, a connection with higher density can be achieved.

Furthermore, since an electric connecting member can have a pitch which is apparently larger than a substantial pitch, its production becomes easier, and this fact is useful in reducing cost. Moreover, breakdown voltage between adjacent conductive members increases and electric properties, such as leakage current, are improved. Hence, it is possible to provide an electric circuit device which has an excellent reliability.

In the present invention, since electrically conductive members exposed from a support member of an electric connecting member have a wave-like or S-like form, connection can be firmly maintained even if, for example, any force is applied to connecting regions from any directions. Accordingly, it is possible to provide an electric circuit device which has excellent mechanical and structural properties and reliability. Such properties can be more remarkably provided when connection is performed by a method other than interdiffusion of metals and/or alloy formation.

When electric circuit components are connected together by interdiffusion of metals and/or alloy formation via an electric connecting member, the electric circuit components are firmly (strongly in strengh) and securely connected together. Hence, it is possible to provide an electric circuit device which has a low connection resistance and small variations, and which is also mechanically strong and has an extremely low failure rate.

Furthermore, when electric circuit components are connected together by interdiffusion of metals and/or alloy formation via an electric connecting member, it is not necessary to hold elecric circuit components using jigs and the like during production process and after production of an electric circuit device, and production of an electric circuit device and its administration after production are easy.

When all electric circuit components are connected by interdiffusion of metals and/or alloy formation via an electric connecting member, it is possible to provide an electric circuit device in which electric circuit components are firmly (strong in mechanical strength) and securely connected together and which has an extremely low failure rate.

When all electric circuit components are connected by interdiffusion of metals and/or alloy formation via an electric connecting member, contact resistance between electric circuit components become smaller compared with a case when only one electric circuit component is connected.

When electric circuit components are removably connected together, it becomes possible to replace failed components by other electric circuit components even if various kinds of failures occur, and reduce costs, such as production cost.

If the melting point of the metal layer or alloy layer formed by interdiffusion of metals and/or alloy formation in the electric circuit components to be removed is made to be lower than the melting point in other electric circuit components, electric circuit components are firmly (strongly in strength) and securely connected together while using an electric circuit device. Hence, it is possible to provide an electric circuit device which has a low connection resistance and variances and is also mechanically strong, and it is also possible to replace only electric circuit components in which a failure occurs by raising the temperature of at least the connecting layer of the electric circuit components in which the failure occurs at a temperature no lower than the melting point of this connecting layer and lower than the melting point of the connecting layer of the electric circuit components not to be replaced to melt the connecting layer of the failed electric circuit component. It is thus possible to reduce costs, such as a production cost.

When performing resin sealing, it is possible to inject a sealant at a high pressure. Hence, it is possible to perform sealing not only by a thermosetting resin for constant-pressure transfer, but also by a thermoplastic resin for which a high-pressure injection is needed.

When one or both of a powder and fibers of one kind or plural kinds of metals, alloys and ceramics are dispersed in a sealant, since the coefficient of thermal expansion of the sealant is close to the coefficient of thermal expansion of the electric circuit component, it is possible to provide an electric circuit device and, as a result, a semiconductor device in which there is less generation of thermal stress even if heat is applied, and which has a high reliability.

Furthermore, if one kind or plural kinds of metals, alloys and ceramics as materials having excellent heat conductive properties are selected and dispersed in the sealant, the heat generated from the electric circuit components is rapidly radiated, and it is possible to provide an electric circuit device and, as a result, a semiconductor device having an excellent heat-radiating property.

When cap sealing is performed, since an electric circuit device is hollow, thermal stress is less generated, and it is possible to provide an electric circuit device which has a high reliability. Furthermore, when a cap is contacted to an electric circuit component, and a material having a high heat-conductive property is used for the cap, the heat generated from the electric circuit component is rapidly conducted to the outside via the cap, it is possible to provide an electric circuit device having an excellent heat-radiating property. In addition, when the cap is made of a material having an excellent noise-shielding property, particularly a metal such as an iron-system metal, it is possible to provide an electric circuit device having an excellent shielding effect.

When a member for adjustment is provided between the cap and the electric circuit component, it becomes possible to effectively perform assembly even when variations in the height of electric circuit components occur.

When a plate is connected to at least a part of the surface of a sealant, when a plate is connected to an electric circuit component and at least a part of at least one of the them is buried by a sealant, and when at least a part of a plate disposed at near an electric circuit component is buried, it is possible to release stress concentration even if an internal stress is produced within the device or a force is applied from the outside, and prevent cracks and the like which may sometimes be produced due to stress concentration. The plate also has an effect for lengthening a path from the outside up to electric circuit components, and hence water and the like from the outside hardly penetrate into electric circuit components. Hence, it is possible to improve reliability of the device.

When the material of the plate is a metal, or ceramics, carbon, or diamond which are excellent in heat conductive property, the heat generated from electric circuit components can be promptly radiated to the outside. Hence, it is possible to provide an electric circuit device which is excellent in heat-radiating property. Furthermore, when the material of the plate is a metal, it is possible to interrupt a noise from the outside, and it is possible to provide an electric circuit device having excellent properties which is less influenced by a noise, also can interrupt electromagnetic noises generated in electric circuit components and generates less noise.

When one kind or plural kinds of metal material powder or fibers are included in an insulating material of a support member of an electric connecting member, it is possible to provide an electric circuit component having a high shielding effect.

When a support member of an electric connecting member is configured by dispersing one or both of a powder or fibers consisting of one kind or plural kinds of metal materials and inorganic materials having excellent heat conductive properties , or when a support member is configured by insulating a metal material in an insulator so that an electric conductive member is insulated, the heat generated from an electric circuit component is radiated to the outside via the electric connecting member and, in addition, other electric circuit components. Hence, it is possible to provide an electric circuit device having an excellent heat-radiating property.

If one or both of a powder and fibers of one kind or plural kinds of metal materials and inorganic materials, which have the coefficient of thermal expansion relatively close to the coefficient of thermal expansion of the electric circuit component, are dispersed in an insulator of an electric connecting member, the coefficient of thermal expansion of the resultant material becomes close to the coefficient of thermal expansion of the electric circuit component. Hence, it is possible to provide an electric circuit device and, as a result, a semiconductor device in which thermal stress is less generated even if heat is applied, and which has a high reliability.

## Claims

1. An electric circuit device comprising:
an electric connecting member (125) including a support member (111) made of an electrically insulating material and plural electrically conductive members (107), buried in said support member (111) and being isolated from one another, first ends (109) of said electrically conductive members (107) being exposed at one surface of said support member (111), and second ends (108) of said electrically conductive members (107) being exposed at the opposite surface of said support member (111);
a first electric circuit component (104) having contact regions (105) to which said first ends (109) of said electrically conductive members (107) are connected; and
a second electric circuit component (101) having contact regions (102) to which said second ends (108) of said electrically conductive members (107) are connected, said electric circuit device being **characterized in that**
the cross-sectional shape of said exposed ends (108, 109) of at least those of said electrically conductive members (107) being embedded in said insulating support member (111) in the circumference thereof is wave-like or S-like.

2. An electric circuit device according to claim 1,
**characterized in that** said exposed ends (108, 109) are arranged in a zigzag form.

3. An electric circuit device according to claim 1 or 2,
**characterized in that**
said first and second electric circuit components (104, 101) are connected by interdiffusion of metals and/or alloy formation.

## Patentansprüche

1. Elektrische Schaltungsanordnung, mit
einem elektrischen Anschlußelement (125), das ein aus einem elektrisch isolierenden Material hergestelltes Halteelement (111) und mehrere elektrisch leitfähige Elemente (107) enthält, die in das Halteelement (111) eingelegt sind und voneinander isoliert sind, wobei erste Endabschnitte (109) der elektrisch leitfähigen Elemente (107) auf einer Fläche des Halteelements (111) freiliegen und zweite Endabschnitte (108) der elektrisch leitfähigen Elemente (107) auf der entgegengesetzten Fläche des Halteelements (111) freiliegen,
einem ersten elektrischen Schaltungsbauteil (104), das Kontaktbereiche (105) hat, mit welchen die ersten Endabschnitte (109) der elektrisch leitfähigen Elemente (107) in Verbindung stehen, und
einem zweiten elektrischen Schaltungsbauteil (101), das Kontaktbereiche (102) hat, mit welchen die zweiten Endabschnitte (108) der elektrisch leitfähigen Elemente (107) in Verbindung stehen, wobei die elektrische Schaltungsanordnung dadurch gekennzeichnet ist, daß
die Querschnittsform der freiliegenden Endabschnitte (108, 109) von mindestens denen der elektrisch leitfähigen Elemente (107), die in das isolierende Halteelement (111) eingebettet sind, in ihrem Umfang wellenähnlich oder S-förmig ist.

2. Elektrische Schaltungsanordnung gemäß Anspruch 1, **dadurch gekennzeichnet, daß** die freiliegenden Endabschnitte (108, 109) in einer Zickzack-Form angeordnet sind.

3. Elektrische Schaltungsanordnung gemäß Anspruch 1 oder 2, **dadurch gekennzeichnet, daß**
das erste elektrische Schaltungsbauteil und das zweite elektrische Schaltungsbauteil (104, 101) durch Interdiffusion von Metallen und/oder Legierungsbildung verbunden sind.

## Revendications

1. Dispositif à circuit électrique comprenant :
un élément (125) de connexion électrique comportant un élément de support (111) réalisé en un matériau électriquement isolant et plusieurs éléments (107) électriquement conducteurs, encastrés dans ledit élément de support (111) et étant isolés les uns des autres, les premières extrémités (109) desdits éléments (107) électriquement conducteurs étant exposées à une surface dudit élément de support (111) , et les secondes extrémités (108) desdits éléments (107) électriquement conducteurs étant exposées à la surface opposée dudit élément de support (111);
un premier composant (104) de circuit électrique ayant des régions de contact (105) auxquelles lesdites premières extrémités (109) desdits éléments (107) électriquement conducteurs sont connectées; et
un second composant (101) de circuit électrique ayant des régions de contact (102) auxquelles lesdites secondes extrémités (108) desdits éléments (107) électriquement conducteurs sont connectés, ledit dispositif à circuit électrique étant **caractérisé en ce que**
la coupe transversale desdites extrémités opposées (108, 109) d'au moins ceux des éléments (107) électriquement conducteurs, qui sont encastrés dans ledit élément de support isolant (111) à sa circonférence, est en forme d'onde ou en forme de S.

2. Dispositif à circuit électrique selon la revendication 1, **caractérisé en ce que** lesdites extrémités opposées (108, 109) sont disposées en zigzag.

3. Dispositif à circuit électrique selon la revendication 1 ou 2, **caractérisé en ce que**
lesdits premier et second composants (104, 101) de circuit électrique sont connectés par diffusion interne de métaux et/ou formation d'alliage.
